# EUROPÄISCHE PATENTANMELDUNG

(11) **EP 3 273 444 A1**
(43) Veröffentlichungstag der Anmeldung: **24.01.2018**
(21) Anmeldenummer: 17001319.7
(22) Anmeldetag: 08.05.2010
(51) Int. Cl.: G11C 13/00, G11C 13/02, G11C 11/56, H03K 19/177

(54) **SPEICHERELEMENT, STAPELUNG, SPEICHERMATRIX UND VERFAHREN ZUM BETREIBEN**

(30) Priorität: 29.05.2009 DE 102009023153; 29.05.2009 EP 09007199; 19.08.2009 WO PCT/EP2009/006015; 04.12.2009 DE 102009056740
(62) Teilanmeldung aus: 10724255.4
(71) Anmelder: Forschungszentrum Jülich GmbH, 52425 Jülich (DE); Rheinisch-Westfälische Technische Hochschule Aachen, 52062 Aachen (DE)
(72) Erfinder: Rosezin, Roland Daniel, 83233 Bernau am Chiemsee (DE); Linn, Eike, 52146 Würselen (DE); Kügeler, Carsten, 59557 Lippstadt (DE); Waser, Rainer, 52076 Aachen (DE)

(57) **Zusammenfassung**

Die Erfindung betrifft ein Speicherelement, eine Stapelung und eine Speichermatrix, in denen dieses Speicherelement einsetzbar ist, Verfahren zum Betreiben der Speichermatrix sowie Verfahren zur Bestimmung des Wahrheitswerts einer logischen Verknüpfung in einer Anordnung aus den Speicherelementen. Das Speicherelement weist mindestens einen ersten stabilen Zustand 0 und einen zweiten stabilen Zustand 1 auf. Durch Anlegen einer ersten Schreibspannung V₀ lässt sich dieses Speicherelement in den hochohmigen Zustand 0 und durch Anlegen einer zweiten Schreibspannung V₁ in den ebenfalls hochohmigen Zustand 1 überführen. Bei Anlegen einer Auslesespannung V_{R}, welche betragsmäßig kleiner ist als die Schreibspannungen V₀ und V₁, zeigt das Speicherelement unterschiedliche elektrische Widerstandswerte. Das Speicherelement fungiert in den in einer Speichermatrix auftretenden parasitären Strompfaden als hochohmiger Widerstand, ohne dabei prinzipiell auf unipolares Schalten eingeschränkt zu sein. Es wurde ein Verfahren entwickelt, mit dem eine Anordnung aus den erfindungsgemäßen Speicherelementen zu einem Gatter für beliebige logische Verknüpfungen gemacht werden kann.

## Beschreibung

Die Erfindung betrifft ein Speicherelement, eine Stapelung und eine Speichermatrix, in denen dieses Speicherelement einsetzbar ist, sowie Verfahren zum Betreiben des Speicherelements, der Stapelung und der Speichermatrix und ein Verfahren zur Bestimmung des Wahrheitswerts einer logischen Verknüpfung mit Speicherelementen.

### Stand der Technik

Ladungsbasierte Speicher, wie etwa Flash-Speicher, stehen kurz davor, die physikalischen Grenzen der Miniaturisierung zu erreichen. Auf Grund ihrer Komplexität nehmen sie zum einen bei gegebener minimaler Featuregröße F mehr Fläche ein als die idealen 4F². Zum anderen ist die minimale Featuregröße F selbst limitiert. Speicher auf der Basis passiver, resistiv schaltender Speicherzellen sind auf einer Fläche von 4F² realisierbar, und eine minimale Featuregröße F von unter 10 nm ist technisch vorstellbar.

Eine Vielzahl von Speicherzellen wird üblicherweise in einer Speichermatrix aus sich kreuzenden, Wordlines und Bitlines genannten Sammelschienen zusammengefasst. Dabei ist zwischen eine Wordline und eine Bitline jeweils genau eine Speicherzelle geschaltet, so dass diese durch Ansteuerung der Wordline und der Bitline individuell adressiert werden kann. Nachteilig gibt es in diesem Konzept bei Verwendung rein passiver, resistiver Speicherzellen zwischen einer Wordline und einer Bitline neben dem direkten Strompfad durch die adressierte Speicherzelle noch parasitäre Strompfade durch weitere Speicherzellen, Wordlines und Bitlines. Es entsteht eine große Verlustleistung, und da die Konfiguration der parasitären Strompfade von den in der Speichermatrix abgelegten Bitmustern abhängt, leidet die Zuverlässigkeit der Speicherung.

Um jeden parasitären Strompfad an mindestens einer Stelle zu unterbrechen, ist es bekannt, ein Speicherelement als Serienschaltung aus einer Speicherzelle und einem nichtlinearen Bauelement, wie etwa einer Diode, vorzuschlagen. Nachteilig können in einer solchen Schaltung nur unipolar resistiv schaltende Speicherzellen verwendet werden, da das nichtlineare Bauelement eine Vorzugsrichtung vorgibt. Das Problem der parasitären Strompfade wird lediglich ersetzt durch das Problem, dass unipolar schaltende Speicherzellen hohe Spannungen zum Schalten benötigen. Die daraus resultierenden hohen Ströme bewirken wiederum eine hohe Verlustleistung und verschlechtern die Skalierungseigenschaften. Auch gibt es bislang keine ausreichend miniaturisierten Dioden, die die geforderten Stromdichten tragen können.

### Aufgabe und Lösung

Es ist daher die Aufgabe der Erfindung, ein Speicherelement zur Verfügung zu stellen, das in den in einer Speichermatrix auftretenden parasitären Strompfaden als hochohmiger Widerstand fungiert, ohne dabei prinzipiell auf unipolares Schalten eingeschränkt zu sein. Es ist die weitere Aufgabe der Erfindung, ein Verfahren zur Verfügung zu stellen, mit dem eine Anordnung aus Speicherelementen zu einem Gatter für logische Verknüpfungen gemacht werden kann.

Diese Aufgaben werden erfindungsgemäß gelöst durch ein Speicherelement gemäß Hauptanspruch, eine dieses Speicherelement enthaltende Stapelung, eine dieses Speicherelement oder diese Stapelung enthaltende Speichermatrix, durch Verfahren zum Betreiben des Speicherelements, der Stapelung oder Speichermatrix gemäß Nebenansprüchen sowie ein Verfahren zur Bestimmung des Wahrheitswerts einer logischen Verknüpfung gemäß weiterem Nebenanspruch. Weitere vorteilhafte Ausgestaltungen ergeben sich jeweils aus den darauf rückbezogenen Unteransprüchen.

### Gegenstand der Erfindung

Im Rahmen der Erfindung wurde ein Speicherelement entwickelt, das mindestens einen ersten stabilen Zustand 0 und einen zweiten stabilen Zustand 1 aufweist. Durch Anlegen einer ersten Schreibspannung V₀ lässt sich dieses Speicherelement in den Zustand 0 und durch Anlegen einer zweiten Schreibspannung V₁ in den Zustand 1 überführen. Die beiden Zustände 0 und 1 unterscheiden sich insoweit, als das Speicherelement bei Anlegen einer Auslesespannung V_{R}, welche betragsmäßig kleiner ist als die Schreibspannungen V₀ und V₁, unterschiedliche elektrische Widerstandswerte zeigt.

Erfindungsgemäß weist das Speicherelement eine Serienschaltung von mindestens zwei Speicherzellen A und B auf, welche jeweils einen stabilen Zustand A0 bzw. B0 mit höherem elektrischem Widerstand und einen stabilen Zustand A1 bzw. B1 mit geringerem elektrischem Widerstand aufweisen.

Es wurde erkannt, dass diese Serienschaltung eine am Speicherelement angelegte Spannung V₀, V₁ beziehungsweise V_{R} im Sinne eines Spannungsteilers auf die beiden Speicherzellen A und B verteilt. Dadurch können die beiden Speicherzellen A und B unabhängig voneinander beeinflusst werden, sofern sie sich in unterschiedlichen Zuständen befinden. Befindet sich etwa die Speicherzelle A im Zustand A0 und die Speicherzelle B im Zustand B1, so fällt der größere Teil der angelegten Spannung über der Speicherzelle A ab. Die Speicherzelle A kann dann durch das Anlegen einer Spannung in den Zustand A1 umgeschaltet werden, ohne dass die hierfür über das gesamte Speicherelement und damit auch über die Reihenschaltung der Zellen A und B angelegte Spannung den Zustand der Zelle B ändert.

Es wurde erkannt, dass sich durch diese Art der Verschaltung speziell in einer Matrix aus vielen Speicherelementen ein einzelnes Speicherelement gezielt ansprechen lässt, ohne dass hierbei die Zustände anderer Speicherelemente geändert werden. In einer solchen Matrix ist es regelmäßig nicht praktikabel, für jedes einzelne Speicherelement einen getrennten Stromkreis vorzusehen. Stattdessen ist jedes Speicherelement in der Regel zwischen eine erste Sammelschiene (üblicherweise Wordline genannt) und eine zweite Sammelschiene (üblicherweise Bitline genannt) geschaltet, an die jeweils viele weitere Speicherelemente angeschlossen sind. Dabei sind eine gegebene Wordline und eine gegebene Bitline nur über ein Speicherelement direkt miteinander verbunden, so dass durch Anlegen einer Spannung zwischen dieser Wordline und Bitline dieses eine Speicherelement individuell angesprochen werden kann. Ein Strom kann jedoch auch auf parasitären Umwegen über weitere Speicherelemente und damit über weitere Word- und Bitlines zwischen derjenigen Wordline und derjenigen Bitline fließen, zwischen denen die Spannung angelegt wird. Damit werden nachteilig auch diese weiteren Speicherelemente mit einer Spannung beaufschlagt. Der erfindungsgemäß vorgesehene Spannungsteiler aus den Speicherzellen A und B hat in einer solchen Matrix die Wirkung, dass der Sicherheitsabstand zwischen der Spannung, die zum Umschalten eines Speicherelements mindestens erforderlich ist, und der Spannung, ab der weitere Speicherelemente auf den besagten parasitären Pfaden ungewollt umgeschaltet werden, vorteilhaft vergrößert wird.

Es wurde außerdem erkannt, dass das erfindungsgemäße Speicherelement immer dann, wenn mindestens eine der Speicherzellen A oder B sich im Zustand A0 beziehungsweise B0 befindet, einen hochohmigen Widerstand darstellt. In drei der vier in der Serienschaltung realisierbaren Kombinationen aus Zuständen (A0 und B1, A1 und B0, A0 und B0) ist der Gesamtwiderstand des Speicherelements daher hoch. Es gibt also unterscheidbare Zustände im Speicherelement, die für die Speicherung eines Bits Information genutzt werden können und in denen der Gesamtwiderstand jeweils hoch ist. Somit kann das Speicherelement unabhängig davon, ob in ihm gerade eine 0 oder eine 1 abgelegt ist, in parasitären Strompfaden als hochohmiger Widerstand fungieren. Dabei können die Speicherzellen jeweils auch bipolar schaltend ausgestaltet sein. Die prinzipielle Einschränkung auf unipolar schaltende Speicherzellen, die die aus dem Stand der Technik bekannte Serienschaltung aus Speicherzelle und nichtlinearem Bauelement mit sich bringt, entfällt.

In einer besonders vorteilhaften Ausgestaltung der Erfindung sind die Speicherzellen A und B derart verschaltet, dass der Zustand 0 des Speicherelements in der Kombination der Zustände A1 und B0 kodiert ist und dass der Zustand 1 des Speicherelements in der Kombination der Zustände A0 und B1 kodiert ist. Dies hat die Wirkung, dass das Speicherelement in beiden Zuständen einen hohen Gesamtwiderstand aufweist. Befindet sich das Speicherelement im Ruhezustand, fällt über ihm also eine geringere Spannung als die zum Auslesen benötigte Auslesespannung V_{R} ab, so führt diese Spannung nur zu einem sehr geringen Leckstrom. Hierdurch wird insbesondere in einer Speichermatrix aus vielen Speicherelementen der unerwünschte Leckstrom durch parasitäre Strompfade eingedämmt.

In einer weiteren besonders vorteilhaften Ausgestaltung der Erfindung sind die Speicherzellen A und B sowie die Auslesespannung V_{R} derart dimensioniert, dass die Auslesespannung V_{R} den Zustand A1 einstellt und den Zustand der Speicherzelle B unverändert lässt.

Befindet sich in dieser Ausgestaltung das Speicherelement im Zustand 0, ändert diese Auslesespannung V_{R} nichts am Zustand der Speicherzellen, denn die Speicherzelle A befindet sich bereits im Zustand A1. Damit ändert sich auch der elektrische Widerstand nicht. Er ist durch die im Zustand B0 befindliche Speicherzelle B dominiert und bleibt daher hoch.

Befindet sich das Speicherelement dagegen im Zustand 1, wird die Speicherzelle A durch die Auslesespannung V_{R} vom Zustand A0 in den Zustand A1 und damit in den Zustand mit geringerem elektrischem Widerstand geschaltet. Da sich die Speicherzelle B im Zustand B1 befindet und daher ebenfalls im Zustand mit dem geringeren elektrischen Widerstand befindet, ist der Gesamtwiderstand des Speicherelements niedrig. Die Kombination der Zustände A1 und B1 der Speicherzellen ist der Zustand ON des Speicherelements. Auf diese Weise können beim Anlegen der Auslesespannung V_{R} die Zustände 0 und 1 des Speicherelements voneinander unterschieden werden. Das Auslesen eines Zustandes 1 ist destruktiv, das heißt, das Speicherelement kehrt nach dem Auslesen nicht von selbst wieder in den Zustand zurück, der vor dem Auslesen vorgelegen hat. Durch Anlegen der Schreibspannung V₁ kann das Speicherelement zurück in den Zustand 1 überführt werden.

Die Speicherzellen A und B können sich auch in der Kombination der Zustände A0 und B0 befinden. Dies tritt in der Regel nur vor der ersten Verwendung des Speicherelements auf. Durch Anlegen der Schreibspannung V₀, beziehungsweise V₁, kann das Speicherelement aus diesem Zustand heraus in einen der für die Speicherung vorgesehenen Zustände 0 oder 1 initialisiert werden. Insbesondere können vor der ersten Verwendung alle Speicherelemente in einer Speichermatrix in dieser Weise initialisiert werden.

Es wurde erkannt, dass in dieser Ausgestaltung des Speicherelements in einer Matrix aus vielen Speicherelementen der Stromfluss durch parasitäre Strompfade zwischen der mit der Auslesespannung V_{R} beaufschlagten Wordline und Bitline vorteilhaft minimiert wird. Nur an der Speicherzelle A des direkt angesprochenen Speicherelements fällt ein ausreichend hoher Anteil der Auslesespannung V_{R} ab, um diese Speicherzelle gegebenenfalls vom Zustand A0 in den Zustand A1 umzuschalten. Entlang jedes unerwünschten parasitären Pfades durch eine Mehrzahl weiterer Speicherelemente fällt über jedes einzelne Speicherelement dagegen nur ein Teil der Auslesespannung V_{R} ab, der nicht ausreicht, um die jeweilige Speicherzelle A in den Zustand A1 zu schalten. Somit eröffnet das Anlegen der Auslesespannung V_{R} nur einen einzigen Pfad mit geringem Widerstand zwischen der Wordline und der Bitline, zwischen denen sie angelegt wurde, sofern das direkt zwischen diese Wordline und diese Bitline geschaltete Speicherelement sich im Zustand 1 befindet. Der elektrische Widerstand aller anderen Speicherelemente auf parasitären Pfaden bleibt in jedem Fall hoch.

Vorteilhaft weisen die Schreibspannungen V₀ und V₁ unterschiedliche Vorzeichen auf. Dies lässt sich insbesondere in einer weiteren besonders vorteilhaften Ausgestaltung der Erfindung realisieren, in der die Speicherzellen A und B antiseriell verschaltet sind. Durch im Vorzeichen unterschiedliche Schreibspannungen V₀ und V₁ entfällt die Notwendigkeit, einen großen betragsmäßigen Abstand zwischen den Schreibspannungen V₀ und V₁ vorzusehen, um deren Wirkungen auf das Speicherelement auch unter Berücksichtigung der technischen Toleranzen noch sicher voneinander unterscheiden zu können. Insbesondere können die Schreibspannungen V₀ und V₁ entgegengesetzt gleich sein. Zwischen ihnen besteht dann ein Abstand vom Doppelten ihres Betrages, so dass der Betrag vorteilhaft geringer dimensioniert sein kann. Sind die Speicherzellen A und B antiseriell verschaltet, so bewirkt das Anlegen der Schreibspannung V₀ oder V₁ jeweils das gleichzeitige bzw. quasi-gleichzeitige Umschalten der Speicherzellen A und B in entgegen gesetzte Zustände, also in A0 und B1 beziehungsweise A1 und B0. Dies sind die beiden stabilen Zustände 1 und 0 des Speicherelements.

Die Erfindung bezieht sich somit allgemein auf ein resistives Speicherelement, das als passives resistives Speicherelement ausgestaltet ist. Dieses Speicherelement umfasst zwei zumindest funktionell identische resistive Speicherzellen A und B, die in einem Strompfad in Reihe geschaltet sind und in diesem Strompfad antiparallel zueinander orientiert sind. Die Speicherzellen A und B sind dann antiseriell verschaltet. Passiv bedeutet, dass das Speicherelement abgesehen vom aktiven Material in den Speicherzellen A und B keine weiteren aktiven schaltenden Elemente enthält. Insbesondere kann der Strompfad durch die Speicherzellen A und B das passive Speicherelement bilden.

Unterschiedliche Vorzeichen der Schreibspannungen V₀ und V₁ sind insbesondere dann realisiert, wenn das Speicherelement als bipolar schaltendes Speicherelement ausgebildet ist. Dies lässt sich beispielsweise realisieren, indem die Speicherzellen A und B aus einem linear bipolar resistiv schaltenden Material gebildet sind. Solche Materialien sind beispielsweise Siliziumdioxid, Methylsilsesquioxan, methyliertes-hydrogeniertes Silsesquioxan, Wolframoxid (insbesondere Wolfram(VI)oxid WO₃), Germaniumselenid, Titandioxid oder Strontiumtitanat. Vorteilhaft enthält also mindestens eine der Speicherzellen A oder B mindestens ein Material aus dieser Gruppe als aktives Material mit veränderlichem elektrischem Widerstand.

Je geringer die Spannungen sind, mit der resistive Speicherzellen beaufschlagt werden, desto weniger Strom wird von dieser Spannung durch die Speicherzellen getrieben und desto weniger Leistung wird im Betrieb verbraucht. Ein geringerer Energieverbrauch geht zugleich mit einer geringeren Wärmebelastung des Speicherelements und damit auch mit einer verbesserten Lebensdauer einher. Auch die kleine irreversible Schädigung, die eine Speicherzelle bei jedem Umschaltvorgang erleidet, hängt stark von der betragsmäßigen Größe der Schreibspannung ab. Bei einer geringeren Schreibspannung übersteht die Speicherzelle eine deutlich größere Anzahl von Umschaltvorgängen. Bei Flash-Speichern nach dem Stand der Technik, die Ladungen mit hohen Schreibspannungen bis zu 10 V gewaltsam durch eine Barriere treiben, ist die Schädigung durch das Schreiben ein technologisch begrenzender Faktor. Sukzessive Verluste an Speicherzellen sind in solchem Maße Normalität, dass die zur Ansteuerung verwendeten Controller Funktionalitäten zur Verwaltung dieser Verluste benötigen.

Ist nun beispielsweise das Speicherelement als bipolar schaltendes Speicherelement ausgebildet, sind betragsmäßig geringere Schreibspannungen erforderlich als für unipolar schaltende Speicherelemente. Es wird daher ein geringerer Strom durch das Speicherelement getrieben. Somit fällt weniger Verlustleistung an, und das Speicherelement ist besser skalierbar.

Die Speicherzellen A und B weisen vorteilhaft in den Zuständen A0 und B0, bzw. A1 und B1, jeweils nominell gleiche Widerstandswerte auf. Dann ist der Gesamtwiderstand des Speicherelements in den beiden Zuständen 0 und 1 exakt gleich, sofern nur eine Spannung unterhalb der Auslesespannung V_{R} über dem Speicherelement anliegt. Abweichungen von diesem nominellen Widerstandswert können zur Diagnose verwendet werden, um ein sich abzeichnendes Versagen des Speicherelements frühzeitig zu erkennen. Dann kann beispielsweise, wie in Flash-Speichern üblich, die Information in ein Reserve-Speicherelement ausgelagert und das vor dem Versagen stehende Speicherelement als defekt ausgeblendet werden.

Vorteilhaft sind die Speicherzellen A und B derart dimensioniert, dass sich der elektrische Widerstand mindestens einer der Speicherzellen A und B beim Übergang vom Zustand A0 in den Zustand A1, bzw. vom Zustand B0 in den Zustand B1, um einen Faktor zwischen 10 und 10⁸, bevorzugt zwischen 10² und 10⁶ und besonders bevorzugt zwischen 10³ und 10⁵, ändert. Je größer die Änderung des Widerstands in den Speicherzellen ist, umso größer ist der Signalabstand im Widerstand, der sich beim Anlegen der Auslesespannung V_{R} zwischen den Zuständen 0 und 1 des Speicherelements zeigt.

In einer besonders vorteilhaften Ausgestaltung der Erfindung ist das Speicherelement als Stapelung aus einer ersten metallischen, halbleitenden oder leitfähigen oxidischen Elektrode, einer ersten Schicht aktiven Materials mit veränderlichem elektrischem Widerstand, einer zweiten metallischen, halbleitenden oder leitfähigen oxidischen Elektrode, einer weiteren Schicht aktiven Materials mit veränderlichem elektrischem Widerstand und einer dritten metallischen, halbleitenden oder leitfähigen oxidischen Elektrode ausgebildet. Dann bildet die erste Schickt aktiven Materials die Speicherzelle A, und die zweite Schicht aktiven Materials bildet die Speicherzelle B. Die aktiven Materialien der Speicherzellen A und B können gleich oder verschieden sein. Beispielsweise können die Elektroden jeweils aus Platin bestehen, und das aktive Material kann jeweils TiO₂ sein. Eine solche Realisierung als Stapelung lässt sich besonders gut in vorhandene Prozesse der Massenfertigung von resistiven Speichern integrieren. Grundsätzlich kann jedes bipolar schaltende Materialsystem, wie beispielsweise ein Festkörperelektrolyt, verwendet werden. Die Wirkung dieser Ausgestaltung ist nicht daran gebunden, dass die Elektroden und Schichten aktiven Materials als Stapelung übereinander angeordnet sind. Es genügt, wenn das Speicherelement zwei Elektroden umfasst, die eine Anordnung zweier Speicherzellen mit der Außenwelt verbinden, und zwischen diesen zwei Elektroden eine weitere Elektrode angeordnet ist.

In einer vorteilhaften Ausgestaltung der Erfindung unterscheidet sich wenigstens das Metall der zweiten Elektrode vom Material der ersten und/oder der dritten Elektrode. Insbesondere kann mindestens das Metall der zweiten Elektrode edler oder unedler sein als die Metalle der ersten und der dritten Elektrode. Beispielsweise können die erste und die dritte Elektrode aus Kupfer und die zweite Elektrode aus Platin bestehen. Der Unterschied in den Edelkeiten der Elektroden legt dann die Polaritäten der Schreibspannungen fest. Auf dem Weg von der ersten zur zweiten metallischen Elektrode verläuft das Edelkeitsgefälle in einer anderen Richtung als auf dem Weg von der zweiten zur dritten Elektrode. Somit sind die Speicherzellen A und B antiseriell geschaltet. Die zweite Elektrode im Inneren der Stapelung kann optional mit einer Biasspannung beaufschlagt werden. Mit einer solchen Biasspannung kann die Strom-Spannungs-Kennlinie des Speicherelements symmetrisiert werden, falls das aktive Material einer oder beider Speicherzellen eine nicht um den Ursprung symmetrische Strom-Spannungs-Kennlinie aufweist.

Vorteilhaft enthält mindestens eine der Elektroden ein Material aus der Gruppe Au, Cu, Ag, Pt, W, Ti, Al, Ni, TiN, Pd, Ir, Os, IrO₂, RuO₂, SrRuO₃, polykristallines Silizium.

Eine oder mehrere Elektroden können auch aus einem elektrisch leitfähigen Oxid bestehen. Dies kann beispielsweise ein von vornherein leitfähiges Metalloxid sein, aber auch ein zunächst isolierendes Oxid, das durch nachträgliche Dotierung leitfähig gemacht wurde. Elektroden aus einem elektrisch leitfähigen Oxid sind beispielsweise dann vorteilhaft, wenn das aktive Material zu der gleichen Materialklasse gehört. Dann können ähnliche oder sogar gleiche Techniken zur Herstellung der Elektroden und des aktiven Materials verwendet werden. Idealerweise hat dies zur Folge, dass die Elektroden und das aktive Material in-situ ohne Bruch des Vakuums nacheinander auf einem Substrat deponiert werden können. Beispielsweise können Elektroden und aktives Material aus ein und demselben Ausgangsmaterial hergestellt werden, indem lediglich unterschiedliche Depositionsparameter verwendet werden.

In einer weiteren vorteilhaften Ausgestaltung der Erfindung besteht mindestens eine der Speicherzellen A oder B aus zwei Elektroden, an deren gemeinsamer Grenzfläche sich eine Zone mit geänderter Ladungsträgerkonzentration als aktives Material bildet. Diese Zone kann beispielsweise eine Verarmungszone oder auch eine Schottky-Barriere sein. Beispielsweise kann das Material der einen Elektrode ein dotiertes ternäres Metalloxid und das Material der anderen Elektrode ein Metall sein. Ein Beispiel für ein dotiertes ternäres Metalloxid ist Niob-dotiertes SrTiO₃. An der gemeinsamen Grenzfläche mit einer Elektrode aus Platin bildet sich eine Zone, die als aktives Material wirkt.

Diese Ausgestaltung der Erfindung hat den Vorteil, dass die Speicherzelle nur noch aus zwei Schichten besteht. Gerade die Herstellung epitaktischer Schichtsysteme wird mit zunehmender Anzahl Einzelschichten auf Grund der Gitterfehlanpassungen überproportional schwieriger.

In einer weiteren vorteilhaften Ausgestaltung der Erfindung ist ein weiterer Widerstand R mit den Speicherzellen A und B in Serie geschaltet oder in mindestens eine der Speicherzellen A und/oder B eingebracht. Dann können auch Speicherzellen A und/oder B verwendet werden, deren positive und negative Schaltschwellen unterschiedliche Beträge aufweisen. Der Widerstand R gleicht die Schaltschwellen betragsmäßig aneinander an. Er tritt nur in dem Zustand in Aktion, in dem sich beide Speicherzellen A und B jeweils im Zustand geringen elektrischen Widerstands befinden, also die Kombination der Zustände A1 und B1 vorliegt. Er ist vorteilhaft so dimensioniert, dass in dieser Kombination der Zustände über beiden Speicherzellen A und B jeweils die gleiche Spannung abfällt. Das Einbringen des Widerstands in eine der Speicherzellen A und/oder B spart den Platz für einen separaten Widerstand und ist technisch besonders einfach realisierbar. Werden die Speicherelemente etwa durch Abscheidung einer Folge dünner Schichten hergestellt, muss nur ein weiteres Material als Widerstandsschicht in die Schichtfolge eingebracht werden.

Hat eine der Speicherzellen betragsmäßig sehr stark unterschiedliche positive und negative Schaltschwellen und wird dies nicht zumindest teilweise durch den Widerstand R kompensiert, so kann der Fall eintreten, dass ausgehend von der Kombination der Zustände A0 und B1 (Zustand 1 des Speicherelements) die minimal erforderliche Auslesespannung V_{R} bereits die Speicherzelle B in den Zustand B0 umschaltet und somit zugleich als Schreibspannung V₀ wirkt. Das Speicherelement erreicht dann nicht die erfindungsgemäß als Signal für das Vorliegen des Zustands 1 vorgesehene Kombination der Zustände A1 und B1 (Zustand ON des Speicherelements).

Ist das Speicherelement Teil einer Speichermatrix, dann kann der Widerstand R insbesondere auch außerhalb des Speicherelements selbst angeordnet sein. Er kann sich beispielsweise in einer der Zuleitungen befinden, mit denen die Word- und/oder Bitlines der Speichermatrix angesteuert werden. Dann genügt ein einziger Widerstand R für die gesamte Speichermatrix. Sollen mehrere Speicherelemente gleichzeitig angesprochen werden, kann hierfür vorteilhaft ein Widerstand je Zeile bzw. Spalte der Speichermatrix vorgesehen werden. Als Widerstand kann beispielsweise der Drain-Source- bzw. Kollektor-Emitter-Widerstand des für die Ansteuerung der Speichermatrix verwendeten Transistors genutzt werden.

Vorteilhaft enthält mindestens eine der Speicherzellen ein ionenleitendes Material und hier insbesondere GeSe, TiO₂, WO₃ oder MSQ (Methylsilsesquioxan). Mit diesen Materialien konnte in den Versuchen der Erfinder Übereinstimmung zwischen dem theoretisch zu erwartenden und dem experimentell beobachteten Schaltverhalten erzielt werden.

Allgemein kann das aktive Material vorteilhaft mindestens ein Material aus der Gruppe GeₓSe₁₋ₓ, TiOₓ, SiOₓ (insbesondere SiO₂) CuOₓ, ZnOₓ, ZrOₓ, NiOₓ, HfOₓ, WOₓ (insbesondere Wolfram-(VI)-Oxid WO₃), Si₃N₄, SrZrO₃:Cr, Ba₁₋ₓSrₓTiO₃ (insbesondere SrTiO₃), MSQ (Methylsilsesquioxan oder methyliertes-hydrogeniertes Silsesquioxan), HSQ (Wasserstoffsilsesquioxan), Cu:TCNQ (Kupfer:Tetracyanoquinodimethan), (Pr,Ca)MnO₃, (La,Ca)MnO₃, Cu₂S, Ag₂S, (Zn,Cd)S, Al₂O₃, FeO, CoO, MnO₂, In₂O₃, Ta₂O₅, Nb₂O₅ und VO₂ enthalten.

Das aktive Material kann ein Dielektrikum sein, das normalerweise isoliert. Durch Beaufschlagung mit einer genügend hohen Spannung kann mindestens ein innerer Pfad in dem Material gebildet werden, entlang dessen es leitend wird. Dieser Pfad kann durch verschiedene Mechanismen gebildet werden, wie etwa Defekte, Metallmigration und weitere Effekte. Ist der leitende Pfad erst einmal gebildet, kann er unterbrochen werden, wodurch sich der elektrische Widerstand des aktiven Materials erhöht, und er kann wieder hergestellt werden, wodurch sich der elektrische Widerstand vermindert. Die Widerstandswerte können durch die angelegte Spannung oder durch Veränderung einer benachbarten Grenzfläche justiert werden.

Die Erfindung bezieht sich auch auf eine Stapelung aus mindestens zwei Speicherelementen P und Q. In dieser Stapelung ist ein Pol des Speicherelements P über einen für eine externe Beschaltung zugänglichen elektrischen Kontakt O mit einem Pol des Speicherelements Q verbunden. Eine solche Stapelung erhöht die Integrationsdichte. Sie wird dadurch technisch praktikabel gemacht, dass jedes der in ihr enthaltenen erfindungsgemäßen Speicherelemente grundsätzlich einen hochohmigen Widerstand darstellt. Es ist dann und nur dann niederohmig, wenn es durch Anlegen der Auslesespannung V_{R} vom Zustand 1 in den Zustand ON überführt wurde. Dadurch werden sowohl parasitäre Strompfade als auch hohe statische Verlustleistungen mit entsprechender Erwärmung vorteilhaft vermieden.

Indem nun der Kontakt O für eine externe Beschaltung zugänglich ist, können beide Speicherelemente P und Q unabhängig voneinander mit Spannungen gleicher oder unterschiedlicher Polarität beaufschlagt werden. Ist etwa der Kontakt O auf Massepotential (GND), kann der andere Pol des Speicherelements P auf ein positives oder negatives Potential gebracht werden. Über dem Speicherelement P kann somit ein Spannungsabfall eingestellt werden, der auf dieses Speicherelement als Schreibspannung V₀ wirkt, aber auch ein solcher, der als Schreibspannung V₁ wirkt. Es kommt jeweils nicht auf die absoluten Potentialniveaus an, sondern nur auf die Potentialdifferenz zwischen beiden Polen des Speicherelements P. Gleiches gilt für das Speicherelement Q.

Die Speicherelemente können aber auch in der Serienschaltung, in der sie sich in der Stapelung befinden, gemeinsam mit Schreib- oder Auslesespannungen beaufschlagt werden.

Wie oben bei der Diskussion der einzelnen Merkmale des erfindungsgemäßen Speicherelements bereits erläutert wurde, zeigen sich die Vorteile der erfindungsgemäßen Maßnahmen insbesondere in einer Speichermatrix aus vielen Speicherelementen oder Stapelungen derselben. In einer vorteilhaften Ausgestaltung der Erfindung ist das Speicherelement daher an den Einsatz in der Speichermatrix eines resistiven Arbeitsspeichers (RRAM) angepasst. Die Erfindung bezieht sich somit auch auf die Verwendung des Speicherelements in der Speichermatrix eines RRAM.

Im Rahmen der Erfindung wurde eine Speichermatrix mit einer Vielzahl von als Leiterbahnen ausgebildeten Wordlines und diese kreuzenden Bitlines entwickelt. Die Wordlines und/oder die Bitlines können insbesondere parallel zueinander verlaufen. In einer vorteilhaften Ausgestaltung der Erfindung kreuzen jede Wordline und jede Bitline einander an höchstens einem Ort. Insbesondere können die Wordlines auf einer ersten Ebene und die Bitlines auf einer zweiten Ebene angeordnet sein. Die Speichermatrix unterscheidet sich von gattungsgemäßen Speichermatrizen dadurch, dass an Kreuzungsorten von Wordlines und Bitlines erfindungsgemäße Speicherelemente oder Stapelungen derselben angeordnet sind. Dabei sind vorteilhaft die Wordline und die Bitline an jedem Kreuzungsort jeweils mit höchstens einem Speicherelement oder einer Stapelung leitend verbunden. Besonders vorteilhaft ist an jedem Kreuzungsort höchstens ein Speicherelement oder eine Stapelung zwischen die Wordline und die Bitline geschaltet. Die Wordlines und/oder die Bitlines können vorteilhaft zugleich als Elektroden des Speicherelements oder der Stapelung fungieren. Die Featuregröße F in der Speichermatrix beträgt vorteilhaft 10 nm oder weniger.

Es wurde erkannt, dass die erfindungsgemäße Ausbildung des Speicherelements als Spannungsteiler aus zwei, vorzugsweise antiseriell geschalteten, Speicherzellen wesentliche Nachteile gattungsgemäßer Speichermatrizen behebt. Nach dem Stand der Technik floss beim Auslesen und beim Beschreiben eines Speicherelements ein Strom nicht nur durch das aktuell über die ausgewählte Wordline und Bitline adressierte Speicherelement, sondern auch durch parasitäre Strompfade aus einer Mehrzahl weiterer Speicherelemente, Wordlines und Bitlines. Diese parasitären Leckströme werden dadurch minimiert, dass sich ein jedes Speicherelement grundsätzlich in einem Zustand mit hohem elektrischem Widerstand befindet, es sei denn, dieses individuelle Speicherelement wird gerade mit der Auslesespannung V_{R} beaufschlagt. Nach dem Stand der Technik waren Leckströme durch parasitäre Strompfade der begrenzende Faktor für die Größe gattungsgemäßer Speichermatrizen.

Da nicht adressierte Speicherelemente grundsätzlich hochohmig sind, hängen im Gegensatz zu gattungsgemäßen Speichermatrizen die elektrischen Eigenschaften der erfindungsgemäßen Speichermatrix nicht mehr von den eingeschriebenen Bitmustern ab. Diese Bitmusterabhängigkeit erschwerte nach dem Stand der Technik das Auslesen gattungsgemäßer Speichermatrizen und machte ein korrektes Auslesen in vielen Fällen unmöglich.

Die Speichermatrix kann im Rahmen einer Hybrid-CMOS-Technologie eingesetzt werden. Die Speichermatrix kann prinzipiell auch dreidimensional ausgestaltet sein, so dass in ihr erfindungsgemäße Speicherelemente übereinander gestapelt sind.

Für die CMOS-Integration der erfindungsgemäßen Speichermatrix ist es von Vorteil, dass der Widerstand der in dieser Speichermatrix enthaltenen Speicherelemente nicht mehr von den in der Matrix gespeicherten Bitmustern abhängt. Die zur Ansteuerung der Speichermatrix verwendete CMOS-Elektronik muss dann nicht mehr darauf ausgelegt werden, dass der Gesamtwiderstand der Speichermatrix in einem weiten Bereich variieren kann.

Die erfindungsgemäßen Speicherelemente wirken besonders vorteilhaft in der Ausgestaltung der Erfindung, in der die Speichermatrix Stapelungen von Speicherelementen umfasst. Dadurch lässt sich im Endeffekt eine dreidimensionale Speichermatrix realisieren. Hier wirkt es sich besonders vorteilhaft aus, dass das Innere dieser Speichermatrix frei von Transistoren ist. Transistoren benötigen viel Platz und erzeugen hohe Verlustleistungen. Die Größe etwa einer würfelförmigen Anordnung aus transistorbasierten Speicherelementen stößt wegen der ungenügenden Wärmeabfuhr aus der Mitte des Würfels schnell an Grenzen. Diese Grenzen werden durch die erfindungsgemäßen Speicherelemente deutlich ausgedehnt.

Die Speichermatrix kann insbesondere in einem resistiven Arbeitsspeicher (RRAM) Verwendung finden, wo sie die hohe Integrationsdichte und Zugriffsgeschwindigkeit von DRAM mit der Nichtflüchtigkeit von Flash-Speicher verbindet. Die Erfindung bezieht sich somit auch auf einen resistiven Arbeitsspeicher (RRAM), der mindestens eine erfindungsgemäße Speichermatrix umfasst. Die Speichermatrix kann dabei insbesondere eine passive Speichermatrix sein, die nur passive Speicherelemente enthält. Dann kann innerhalb der Speichermatrix auf aktive Schaltelemente, die unabhängig von den Strömen durch die Wordlines und Bitlines ansteuerbar sind, gänzlich verzichtet werden. Ein RRAM enthält neben der Speichermatrix selbst noch eine externe Ansteuerelektronik für die Speicherelemente, die beispielsweise in CMOS-Technologie realisiert sein kann. Dabei kann beispielsweise ein Decoder für die wechselweise Ansteuerung der Wordlines und ein weiterer Decoder für die wechselweise Ansteuerung der Bitlines vorgesehen sein.

Im Rahmen der Erfindung wurde ein Verfahren zum Betreiben des erfindungsgemäßen Speicherelements, der erfindungsgemäßen Stapelung oder der erfindungsgemäßen Speichermatrix entwickelt. Dieses Verfahren ist dadurch gekennzeichnet, dass an mindestens ein Speicherelement eine Auslesespannung V_{R} angelegt wird, die betragsmäßig höher als ein erster Schwellwert ist, der für das Umschalten einer der Speicherzellen A oder B des Speicherelements vom Zustand A0 bzw. B0 in den Zustand A1 bzw. B1 erforderlich ist, wobei die Auslesespannung V_{R} betragsmäßig kleiner als ein zweiter Schwellwert ist, der für das Umschalten der anderen Speicherzelle A oder B des Speicherelements vom Zustand A1 bzw. B1 in den Zustand A0 bzw. B0 erforderlich ist.

Alternativ oder auch in Kombination hierzu kann ein weiteres Verfahren zum Betreiben des erfindungsgemäßen Speicherelements, der erfindungsgemäßen Stapelung oder der erfindungsgemäßen Speichermatrix angewendet werden, das im Rahmen der Erfindung entwickelt wurde. Dieses Verfahren ist dadurch gekennzeichnet, dass die durch Anlegen der Auslesespannung V_{R} an ein Speicherelement ausgelesene Information anschließend erneut in dem Speicherelement hinterlegt wird. Sofern das Anlegen der Auslesespannung V_{R} zu einer Änderung des Gesamtwiderstands des Speicherelements führt, kehrt das Speicherelement nicht von sich aus in den Zustand zurück, der vor dem Anlegen der Auslesespannung V_{R} vorgelegen hat. Das Auslesen ist insofern destruktiv. Dies trifft speziell auf die Ausgestaltung des Speicherelements zu, in der der Zustand 0 des Speicherelements in der Kombination der Zustände A1 und B0 kodiert ist und in der der Zustand 1 des Speicherelements in der Kombination der Zustände A0 und B1 kodiert ist. Nach dem Auslesen einer 1 liegt die Kombination A1 und B1 vor, die keinem der beiden definierten Zustände 0 und 1 des Speicherelements entspricht. Der Zustand 1 wird durch anschließendes Anlegen der Schreibspannung V₁, die die Speicherzelle A in den Zustand A0 zurückversetzt, wieder hergestellt.

Alternativ oder auch in Kombination hierzu bezieht sich die Erfindung auch auf ein weiteres Verfahren zum Betreiben eines Speicherelements, einer Stapelung oder einer Speichermatrix. Im Zuge dieses Verfahrens wird beim Anlegen der Schreibspannung V₀ und/oder V₁ der Zeitverlauf des durch das Speicherelement, durch die Stapelung oder durch die Speichermatrix getriebenen Stroms ausgewertet.

Dieses Verfahren bietet spezielle Vorteile, wenn das Speicherelement in der Ausgestaltung vorliegt, in der der Zustand 0 des Speicherelements in der Kombination der Zustände A1 und B0 kodiert ist und in der der Zustand 1 des Speicherelements in der Kombination der Zustände A0 und B1 kodiert ist.

Es wurde erkannt, dass dann das Umschalten des Speicherelements vom Zustand 0 in den Zustand 1 oder umgekehrt durch das Anlegen der entsprechenden Schreibspannung grundsätzlich in mehreren Stufen verläuft. Sowohl im Zustand 0 als auch im Zustand 1 des Speicherelements befindet sich immer eine der Speicherzellen im Zustand A0 bzw. B0, und die andere Speicherzelle befindet sich im Zustand A1 bzw. B1. Wird an das Speicherelement als Reihenschaltung beider Speicherzellen diejenige Schreibspannung angelegt, die zum Umschalten des Speicherelements in den gerade nicht vorliegenden Zustand geeignet ist, so fällt diese Schreibspannung zunächst im Wesentlichen über derjenigen Speicherzelle ab, die den höheren elektrischen Widerstand aufweist, sich also im Zustand A0 bzw. B0 befindet. In der Folge wird diese Speicherzelle in den Zustand A1 bzw. B1 umgeschaltet. Nun befinden sich beide Speicherzellen im Zustand A1 bzw. B1, das Speicherelement befindet sich also im Zustand ON. Dieser Zustand ist jedoch nur von kurzer Dauer. Die Schreibspannung fällt nun gleichmäßig über beide Speicherzellen A und B ab. Über derjenigen Speicherzelle, die sich schon vor dem Anlegen der Schreibspannung im Zustand A1 bzw. B1 befunden hatte, fällt nun mehr Spannung ab als zu Beginn des Schreibvorgangs. Sie wird daher von dem über ihr abfallenden Anteil der Schreibspannung in den Zustand A0 bzw. B0 umgeschaltet. Am Ende haben beide Speicherzellen jeweils ihren Zustand gewechselt, und das Speicherelement befindet sich insgesamt in einem der beiden Zustände 0 (Kombination A1 mit B0) oder 1 (Kombination A0 mit B1).

Während der kurzen Zeitspanne zwischen dem Umschalten der ersten Speicherzelle und dem Umschalten der zweiten Speicherzelle befindet sich das Speicherelement im Zustand ON, also in einem Zustand mit insgesamt geringem elektrischem Widerstand. Dies macht sich dadurch bemerkbar, dass die Schreibspannung während dieser Zeitspanne einen hohen Strompuls durch die Speicherzelle treibt. Es wurde von den Erfindern erkannt, dass eine Auswertung des Zeitverlaufs des Stroms, also eine Auswertung dieses Pulses, beim Betreiben des Speicherelements, der Stapelung oder der Speichermatrix vielseitig genutzt werden kann.

In einer besonders vorteilhaften Ausgestaltung der Erfindung kann das Auftreten eines kurzen Pulses im durch das Speicherelement, durch die Stapelung oder durch die Speichermatrix getriebenen Strom als Bestätigung für einen erfolgreichen Umschaltvorgang gewertet werden. Theoretisch reicht hierfür eine Pulsdauer von weniger als 1 ps aus. Praktisch nachgewiesen wurden Pulsdauern von 10 ns oder weniger für TiO₂ und Pulsdauern von 5 ns oder weniger für WO₃ als aktives Material der Speicherzellen. Für alle von den Erfindern getesteten aktiven Materialien zeigen sich bei den Umschaltvorgängen Pulsdauern von 10 ns oder weniger.

Mit dem Auftreten und anschließenden Abklingen des Pulses werden die Zustandswechsel beider Speicherzellen bestätigt. Der Puls tritt nur auf, wenn die erste Speicherzelle erfolgreich in den Zustand A1 bzw. B1 umgeschaltet wird und das Speicherelement als Ganzes in den Zustand ON übergeht. Er klingt nur dann wieder ab, wenn anschließend die zweite Speicherzelle in den Zustand A0 bzw. B0 umgeschaltet wird und das Speicherelement somit als Ganzes wieder einen Zustand mit hohem elektrischem Widerstand annimmt. Wird durch eine Schreibspannung, die für ein Umschalten des Speicherelements in den jeweils gerade nicht vorliegenden Zustand geeignet wäre, kein erhöhter Strom durch das Speicherelement getrieben oder klingt dieser nicht wieder ab, ist das Speicherelement defekt.

Das Auftreten des Pulses kann alternativ oder auch in Kombination hierzu als Information über den vor dem Anlegen der Schreibspannung vorliegenden Zustand des Speicherelements gewertet werden. Wird etwa die Schreibspannung V₁ angelegt, so tritt nur dann ein Puls auf, wenn sich das Speicherelement vor dem Anlegen dieser Schreibspannung im Zustand 0 befunden hat. Hat dagegen der Zustand 1 vorgelegen, so fällt die Schreibspannung V₁ im Wesentlichen über der im Zustand A0 befindlichen Speicherzelle A statt, da die Speicherzelle B sich im Zustand B1 befindet und somit niederohmig ist. Die Schreibspannung V1 hat nun aber nicht die richtige Polarität zum Umschalten der Speicherzelle A in den Zustand A1. Beide Speicherzellen A und B, und somit auch das Speicherelement insgesamt, ändern ihren Zustand nicht, so dass kein Puls auftritt.

Auf diese Weise kann beim Schreiben mit den Schreibspannungen V₀ und V₁ gleichzeitig auch die bereits im Speicherelement vorhandene Information ausgelesen werden. Es ist vorteilhaft keine separate Spannungsquelle für eine Auslesespannung V_{R} erforderlich. Im einfachsten Fall sind für den Betrieb nur noch das Massepotential (GND) und ein hiervon verschiedenes Potential V einer einzigen Spannungsquelle erforderlich. Die Polarität, mit der diese beiden Potentiale an die beiden Pole des Speicherelements angelegt werden, entscheidet darüber, ob das Speicherelement mit der Schreibspannung V₀ oder mit der Schreibspannung V₁ beaufschlagt wird.

In einer weiteren vorteilhaften Ausgestaltung der Erfindung wird eine Veränderung im Zeitverlauf des durch das Speicherelement, durch die Stapelung oder durch die Speichermatrix getriebenen Stroms bei wiederholten Schreibzyklen als Indikator für eine beginnende Degradation eines Speicherelements gewertet. Insbesondere in einer Speichermatrix aus sehr vielen Speicherelementen kann dann dieses Speicherelement oder ein begrenztes Gebiet in der Speichermatrix, in dem sich dieses Speicherelement befindet, als defekt markiert und für weitere Zugriffe gesperrt werden.

Je mehr Speicherelemente eine Speichermatrix enthält und je kleiner diese Speicherelemente sind, desto größer ist die Wahrscheinlichkeit, dass eines oder mehrere der Speicherelemente allein schon auf Grund der Streubreiten im Herstellungsprozess nach einer bestimmten Anzahl Schreibzyklen versagen. So ist etwa die Wirkung eines statistisch auftretenden Defekts in einer Schicht einer Speicherzelle deutlich größer, wenn diese Schicht nur aus 100 Atomen besteht, als wenn sie aus 10.000 Atomen besteht.

In einer vorteilhaften Ausgestaltung der Erfindung werden die Schreibspannungen V₀ und/oder V₁ und/oder die Lesespannung V_{R} jeweils zum Teil über die Wordline und über die Bitline vorgelegt. Dabei kann insbesondere über die Wordline und über die Bitline jeweils die Hälfte der Spannung vorgelegt werden. Dieses Spannungsschema (1/2-Schema) verringert vorteilhaft die Spannungen, mit der andere als das durch die Wahl der Wordline und Bitline adressierte Speicherelement beaufschlagt werden. Auf die gleiche Wirkung zielt eine weitere vorteilhafte Ausgestaltung der Erfindung ab. Gemäß dieser Ausgestaltung wird beim Anlegen der Schreibspannungen V₀ und/oder V₁ und/oder der Auslesespannung V_{R} an ein Speicherelement eine Spannung mit anderem Vorzeichen an mindestens ein weiteres Speicherelement angelegt. Dabei können insbesondere an alle nicht adressierten Wordlines Gegenspannungen mit einem Betrag von 2/3 der am adressierten Speicherelement anliegenden Spannung angelegt werden, und an alle nicht adressierten Bitlines können Gegenspannungen mit einem Betrag von 1/3 der am adressierten Speicherelement anliegenden Spannung angelegt werden. Die im Rahmen dieses Spannungsschemas (2/3-Schema) angelegte Gegenspannung mit anderem Vorzeichen kompensiert die Beeinflussung nicht adressierter Speicherelemente durch die an das adressierte Speicherelement angelegte Spannung V₀, V₁ beziehungsweise V_{R} zumindest teilweise.

Die Erfindung bezieht sich auch auf ein Verfahren zur Bestimmung des Wahrheitswerts einer logischen Verknüpfung zweier Variablen K und L in einer Anordnung aus mindestens zwei Speicherelementen P und Q mit jeweils mindestens einem stabilen Zustand 0 und einem stabilen Zustand 1, die jeweils durch Anlegen einer ersten Schreibspannung V₀ in den Zustand 0 und durch Anlegen einer zweiten Schreibspannung V₁ in den Zustand 1 überführbar sind. Vorteilhaft manifestieren sich die beiden Zustände 0 und 1 der Speicherelemente P und Q bei Anlegen einer Auslesespannung V_{R}, die betragsmäßig kleiner ist als die Schreibspannungen V₀ und V₁, in unterschiedlichen elektrischen Widerstandswerten der Speicherelemente P und Q. Vorzugsweise werden Speicherelemente P und Q mit nominell identischen Schreibspannungen V₀, V₁ und Auslesespannungen V_{R} gewählt.

Die Variablen K und L sind jeweils in Form zweier Spannungspegel realisiert, die den Wahrheitswerten 0 und 1 zugeordnet sind, wobei die Differenz der beiden Spannungspegel betragsmäßig mindestens so groß ist wie die Schreibspannungen V₀ und V₁ der Speicherelemente P und Q. Vorteilhaft ist dabei mindestens einer der Spannungspegel betragsmäßig mindestens so groß wie die Schreibspannungen V₀ und V₁ der Speicherelemente P und Q. Beispielsweise kann dem Wahrheitswert 0 das Massepotential (GND) und dem Wahrheitswert 1 ein Spannungspegel V zugeordnet sein, der betragsmäßig größer ist als die Schreibspannungen V₀ und V₁ der Speicherelemente P und Q.

Erfindungsgemäß wird nun mindestens einer der beiden Pole P₁, P₂ des Speicherelements P mit dem Spannungspegel der Variablen K beaufschlagt. Mindestens einer der beiden Pole Q₁, Q₂ des Speicherelements Q wird mit dem Spannungspegel der Variablen L beaufschlagt. Vorteilhaft werden beide Speicherelemente P und Q zuvor in einen definierten Zustand, beispielsweise 0, initialisiert.

Es wurde erkannt, dass sich durch diese Maßnahmen der Wahrheitswert der logischen Verknüpfung der Variablen K und L in den Zuständen der Speicherelemente P und Q speichern lässt und aus diesen Speicherelementen auch ausgelesen werden kann.

So lässt sich beispielsweise in der einfachsten Form das Ergebnis der Verknüpfung "K ODER L" speichern, indem das Speicherelement P zwischen den Spannungspegel der Variablen K und Masse (oder ein anderes frei wählbares Potential) sowie das Speicherelement Q zwischen den Spannungspegel der Variablen L und Masse (oder ein anderes frei wählbares Potential) geschaltet werden.

Hat die Variable K den Wahrheitswert 1, so wird durch den entsprechenden Spannungspegel das Speicherelement P in den Zustand 1 geschaltet. Hat die Variable L den Wahrheitswert 1, so wird analog das Speicherelement Q in den Zustand 1 geschaltet. Ist also mindestens einer der beiden Wahrheitswerte 1, so ist auch mindestens eines der zuvor auf 0 initialisierten Speicherelemente P oder Q im Zustand 1. Der Wahrheitswert 1 der Verknüpfung "K ODER L" ist somit darin verkörpert, dass sich mindestens ein Speicherelement P oder Q im Zustand 1 befindet. Sind dagegen beide Wahrheitswerte 0, so verbleiben beide Speicherelemente P und Q im Zustand 0. Der Wahrheitswert 0 der Verknüpfung "K ODER L" ist darin verkörpert, dass beide Speicherelemente P und Q im Zustand 0 sind. Somit ist das Ergebnis der Verknüpfung in den Zuständen der Speicherelemente P und Q hinterlegt worden.

In einer besonders vorteilhaften Ausgestaltung der Erfindung wird nach der Beaufschlagung der Pole der Speicherelemente P und Q mit den Spannungspegeln der Variablen K und L mindestens eines der Speicherelemente P und Q mit seiner Auslesespannung V_{R} beaufschlagt. Vorteilhaft wird eine Parallelschaltung der Speicherelemente P und Q mit einer Spannung beaufschlagt, die auf beide Speicherelemente P und Q als Auslesespannung V_{R} wirkt. Im genannten Beispiel der Oder-Verknüpfung werden hierzu beide Speicherelemente P und Q jeweils zwischen das Potential der Auslesespannung V_{R} und das Massepotential geschaltet.

Es wurde erkannt, dass dieses Anlegen der Auslesespannung V_{R} einen Strompuls durch das oder die Speicherelemente bzw. durch die Parallelschaltung treibt, sofern in den Zuständen der Speicherelemente P und Q auf die oben beschriebene Weise eine 1 als Ergebnis der Verknüpfung gespeichert worden ist. Dann überführt das Anlegen der Auslesespannung V_{R} mindestens eines der Speicherelemente P und Q aus dem Zustand 1 in den Zustand ON. Entsprechend der erfindungsgemäßen Konstruktion wird das Speicherelement hierdurch niederohmig, und es fließt ein gut detektierbarer Lesestrom. Ist dagegen in den Zuständen der Speicherelemente P und Q eine 0 als Ergebnis der Verknüpfung hinterlegt, befinden sich also beide Speicherelemente im Zustand 0, ändert das Anlegen der Auslesespannung V_{R} hieran nichts. Beide Speicherelemente bleiben hochohmig. Der hohe Lesestrom bleibt aus.

Die Beaufschlagung lediglich eines Speicherelements P oder Q mit der Auslesespannung V_{R} ist dann ausreichend, wenn auf Grund des hierdurch ausgelesenen Zustands der Wahrheitswert der durchgeführten logischen Verknüpfung bereits feststeht. Dann kann ein Arbeitszyklus für das Auslesen des zweiten Speicherelements eingespart werden. Ist etwa im obigen Beispiel der Wahrheitswert der Verknüpfung "K ODER L" in der Anordnung hinterlegt worden, indem das Speicherelement P in den Zustand 1 umgeschaltet wurde, so ist bereits nach dem Auslesen des Speicherelements P mit seiner Auslesespannung V_{R} klar, dass der Wahrheitswert der Verknüpfung 1 ist. Das Speicherelement Q muss gar nicht mehr ausgelesen werden, da sein Zustand am Ergebnis nichts mehr ändert. Liegt der Wahrheitswert der durchgeführten logischen Verknüpfung dagegen nach dem Auslesen des ersten Speicherelements noch nicht fest, befindet sich im obigen Beispiel also das Speicherelement P im Zustand 0, muss auch das zweite Speicherelement (hier Q) ausgelesen werden.

Alternativ oder auch in Kombination zur Beaufschlagung mindestens eines der Speicherelemente mit der Auslesespannung V_{R} werden in einer weiteren besonders vorteilhaften Ausgestaltung der Erfindung die Zeitverläufe der Ströme, die bei der Beaufschlagung der Pole der Speicherelemente P und Q mit den Spannungspegeln der Variablen K und L durch die Anordnung getrieben werden, zur Bestimmung des Wahrheitswerts der logischen Verknüpfung ausgewertet. In der Beschreibung des Verfahrens zum Betreiben eines Speicherelements, einer Stapelung oder einer Speichermatrix wurde bereits herausgearbeitet, dass das Umschalten eines Speicherelements dieses für eine kurze Zeitspanne in den Zustand ON versetzt und somit während dieser Zeitspanne einen Strompuls durch das Speicherelement treibt. Indem nun bei der Beaufschlagung der Pole der Speicherelemente P und Q mit den Spannungspegeln der Variablen K und L nach solchen Pulsen Ausschau gehalten wird, kann vorteilhaft erkannt werden, ob mindestens ein Speicherelement in der Anordnung umgeschaltet wurde.

Im obigen Beispiel der Verknüpfung "K ODER L" wird das Speicherelement P in den Zustand 1 umgeschaltet, wenn der Wahrheitswert von K gleich 1 ist. Das Speicherelement Q wird in den Zustand 1 umgeschaltet, wenn der Wahrheitswert von L gleich 1 ist. Zeigt sich beim Anlegen von K an P oder von L an Q ein Strompuls im durch die Anordnung getriebenen Strom, liefert dies die Information, dass mindestens eines der Speicherelemente P und Q umgeschaltet wurde, der Wahrheitswert der Verknüpfung also gleich 1 ist.

Der Vorteil dieser Ausgestaltung liegt darin, dass sowohl eine separate Spannungsquelle für eine Auslesespannung V_{R} als auch ein Arbeitszyklus für das Auslesen des Ergebnisses aus der Anordnung entbehrlich sind. Das Ergebnis tritt in Form des Strompulses unmittelbar bei seiner Entstehung aus der Anordnung heraus und kann weiter verarbeitet werden, beispielsweise für die Berechnung einer zusammengesetzten logischen Funktion in einem Addierer. Das Ergebnis ist gleichwohl noch in der Anordnung gespeichert und kann durch das Anlegen der Auslesespannung V_{R} an die Parallelschaltung der beiden Speicherzellen P und Q ein weiteres Mal aus der Anordnung extrahiert werden.

In einer besonders vorteilhaften Ausgestaltung der Erfindung werden erfindungsgemäße Speicherelemente P und Q nach einem der auf ein Speicherelement gerichteten Ansprüche gewählt. Die erfindungsgemäßen Speicherelemente bieten im Hinblick auf das Verfahren den entscheidenden Vorteil, dass sie dann und nur dann niederohmig sind, wenn sie durch die Auslesespannung V_{R} vom Zustand 1 in den Zustand ON überführt worden sind. Sie sind ansonsten hochohmig, so dass parasitäre Leckströme vorteilhaft vermieden werden. Dies ist insbesondere wichtig, wenn mit dem Verfahren ein komplexerer logischer Ausdruck ausgewertet werden soll. Sind hierfür beispielsweise viele Speicherelemente in einer Matrix angeordnet, so existierte nach dem Stand der Technik zwischen zwei beliebigen Aufpunkten in dieser Matrix eine Vielzahl von Pfaden für Leckströme, die auch noch davon abhängig waren, welche Bitmuster in der Matrix gespeichert waren. Die Verwendung erfindungsgemäßer Speicherelemente eliminiert diese Leckströme und sorgt insofern dafür, dass das Verfahren verlässliche Wahrheitswerte liefert.

In einer besonders vorteilhaften Ausgestaltung der Erfindung wird eine erfindungsgemäße Stapelung aus Speicherelementen P und Q und/oder eine erfindungsgemäße Speichermatrix als Anordnung aus Speicherelementen gewählt. Es wurde erkannt, dass an den Speicherelementen, an der Stapelung bzw. an der Speichermatrix selbst nichts geändert werden muss, um ihre Funktion von einem Speicher für fest vorgegebene Daten zu einem Speicher für Wahrheitswerte einer logischen Verknüpfung aufzuwerten. Geändert wird nur die Art und Weise, in der die Speicherelemente mit Signalen beaufschlagt werden.

Somit lässt sich ein und dieselbe Hardware zur Laufzeit auf verschiedene Verwendungszwecke umkonfigurieren. Die bisherige strenge Trennung zwischen dem Rechenwerk und dem Speicher eines Mikroprozessors, und damit auch die prinzipielle Begrenzung der Rechengeschwindigkeit durch das Verbindungssystem zwischen Rechenwerk und Speicher ("von Neumann Bottleneck") ist hierdurch aufgehoben. Durch eine geeignete Beschaltung einer Speichermatrix können zudem massiv parallele logische und damit Rechenoperationen durchgeführt werden, wodurch weitere Geschwindigkeitsgewinne möglich sind.

Wird das Verfahren verwendet, um eine Speichermatrix ganz oder teilweise zum Mikroprozessor umzufunktionieren, so wird dadurch ein Mikroprozessor geschaffen, bei dem die massenhaft vorhandenen Funktionselemente frei von Transistoren sind und lediglich einige wenige Transistoren für die periphere Ansteuerung benötigt werden. Nach dem bisherigen Stand der Technik enthält ein Mikroprozessor viele Millionen Transistoren, die sehr viel Platz auf dem Chip beanspruchen. Darüber hinaus sind Transistoren, die aus Halbleitern verschiedener Dotierungen zusammengesetzt sind, wesentlich aufwändiger herzustellen als erfindungsgemäße Speicherelemente.

Die wesentlich geringeren Leckströme und entsprechend geringeren Verlustleistungen der erfindungsgemäßen Speicherelemente machen eine dreidimensionale Speichermatrix, die Stapelungen aus Speicherelementen umfasst, praktikabel. Der begrenzende Faktor für die Größe einer solchen Speichermatrix ist die Wärmeabfuhr aus der Mitte dieser Matrix. Da die erfindungsgemäßen Speicherelemente weniger Wärme produzieren, kann die Matrix deutlich größer werden. Wird eine solche Matrix nun unter Verwendung des erfindungsgemäßen Verfahrens zur Bestimmung des Wahrheitswerts einer logischen Verknüpfung ganz oder teilweise zu einem Mikroprozessor umfunktioniert, kann erstmals ein Mikroprozessor zur Verfügung gestellt werden, dessen Ausdehnung in der Höhe mit seiner Ausdehnung in der Ebene vergleichbar wird. Dabei besteht ständig wahlfreier Zugriff auf jedes Gebiet innerhalb der dreidimensionalen Matrix.

In einer besonders vorteilhaften Ausgestaltung der Erfindung werden die Speicherelemente P und Q mit verschiedenen Polaritäten jeweils zwischen den Spannungspegel der Variablen K und den der Variablen L geschaltet. In dieser Ausgestaltung ist eine exklusive Oder-Verknüpfung (XOR) der Variablen K und L realisiert.

Haben die Variablen K und L den gleichen Wahrheitswert, so fällt weder über dem Speicherelement P noch über dem Speicherelement Q eine Spannung ab. Beide Speicherelemente bleiben in dem Zustand 0, in den sie zu Beginn initialisiert wurden. Wird nun an die beiden Speicherelemente P und Q oder eine Parallelschaltung derselben die Auslesespannung V_{R} angelegt, bleiben beide Speicherelemente hochohmig, und es fließt nur ein sehr geringer Strom durch die Parallelschaltung. Haben die Variablen K und L dagegen unterschiedliche Wahrheitswerte, so liegt die Differenz der entsprechenden Spannungspegel einmal am Speicherelement P und einmal mit umgekehrtem Vorzeichen am Speicherelement Q an. Dann wird eines der beiden Speicherelemente in den Zustand 1 geschaltet. Wird nun die Auslesespannung V_{R} angelegt, wird dieses Speicherelement vom Zustand 1 in den Zustand ON geschaltet. Dieses Speicherelement bildet somit einen niederohmigen Pfad für den durch die Auslesespannung V_{R} getriebenen Strom. Es fließt ein gut detektierbarer Lesestrom durch dieses Speicherelement bzw. durch eine Parallelschaltung beider Speicherelemente P und Q. Alternativ oder auch in Kombination hierzu kann beim gleichzeitigen Anlegen der Spannungspegel von K und L der Zeitverlauf des durch die Anordnung fließenden Stroms ausgewertet werden. Zeigt sich hierin ein kurzer Strompuls, wurde eine der Speicherzellen P oder Q in den Zustand 1 umgeschaltet, und der Wahrheitswert der XOR-Verknüpfung ist 1. Zeigt sich ein solcher Strompuls nicht, wurde keine der beiden Zellen umgeschaltet, und der Wahrheitswert ist 0.

Der Wahrheitswert der Variablen K kann zu "NICHT K" invertiert werden, indem eine XOR-Verknüpfung mit 1 als dem Wahrheitswert der Variablen L durchgeführt wird. Damit lässt sich schließlich auch die Verknüpfung "K UND L" realisieren, indem ein weiteres, auf 0 initialisiertes Speicherelement zwischen den Spannungspegel der Variablen L und den Spannungspegel von "NICHT K" geschaltet wird. Nur wenn beide Spannungspegel unterschiedlich sind, also sowohl K als auch L den Wahrheitswert 1 haben, wird das weitere Speicherelement vom Zustand 0 in den Zustand 1 geschaltet. Aus diesem Zustand kann es durch Anlegen der Auslesespannung V_{R} in den Zustand ON geschaltet werden, woraufhin ein gut detektierbarer Lesestrom fließt.

Aus den hier gezeigten Verknüpfungen ODER, UND, NICHT und XOR und dem damit auch realisierbaren universellen NOR-Gatter lässt sich jede beliebige logische Schaltung zusammensetzen, wie beispielsweise ein Volladdierer zur Addition dreier Wahrheitswerte.

Die XOR-Verknüpfung kann beispielsweise in Faltungscodierern für die Nachrichtentechnik, in kryptographischen Codierern und Dual rail decodern eingesetzt werden.

### Spezieller Beschreibungsteil

Nachfolgend wird der Gegenstand der Erfindung anhand von Figuren näher erläutert, ohne dass der Gegenstand der Erfindung dadurch beschränkt wird. Es ist gezeigt:
- Figur 1:: Strom-Spannungs-Kennlinien zweier Speicherzellen A und B (Teilbilder a und b) sowie einer aus diesen Speicherzellen A und B zusammengesetzten Ausführungs-form des erfindungsgemäßen Speicherelements (Teilbild c).
- Figur 2:: Zeitverlauf von Spannungspulsen, die zum Schreiben und Auslesen an das in Figur 1c gezeigte Speicherelement angelegt werden, mit jeweiliger Antwort des Speicherelements.
- Figur 3:: Auswirkung einer Streuung von 10% in den Kenngrößen der Speicherzellen A und B auf die nutzbare Bandbreite der Schreib- und Auslesespannungen.
- Figur 4:: Ausführungsbeispiel des erfindungsgemäßen Speicherelements, bei dem die Strom-Spannungs-Kennlinie durch einen weiteren, mit den Speicherzellen A und B in Reihe geschalteten Widerstand R symmetrisiert wurde.
- Figur 5:: Ausführungsbeispiel der erfindungsgemäßen Speichermatrix.
- Figur 6:: Vergleich der für einen vorgegebenen Signalhub zwischen dem Auslesen einer 0 und dem Auslesen einer 1 maximal möglichen Anzahl an Speicherelementen in einer Speichermatrix zwischen einer Speichermatrix nach dem Stand der Technik (Teilbild a) und einer erfindungsgemäßen Speichermatrix (Teilbild b).
- Figur 7:: Ausführungsbeispiel des erfindungsgemäßen Verfahrens zur Bestimmung des Wahrheitswerts einer logischen ODER-Verknüpfung: Initialisierung (Teilbild a), Speicherung des Wahrheitswerts (Teilbild b), Auslesen des Wahrheitswerts (Teilbild c).
- Figur 8:: Ausführungsbeispiel des erfindungsgemäßen Verfahrens zur Bestimmung des Wahrheitswerts einer logischen ODER-Verknüpfung, bei dem eine erfindungsgemäße Stapelung von Speicherelementen verwendet wird: Initialisierung (Teilbild a), Speicherung des Wahrheitswerts (Teilbild b), Auslesen des Wahrheitswerts (Teilbild c).
- Figur 9:: Ausführungsbeispiel des erfindungsgemäßen Verfahrens zur Bestimmung des Wahrheitswerts einer logischen XOR-Verknüpfung, das eine erfindungsgemäße Speichermatrix verwendet: Initialisierung (Teilbild a), Speicherung des Wahrheitswerts (Teilbild b), Auslesen des Wahrheitswerts (Teilbild c).
- Figur 10:: Ausführungsbeispiel des erfindungsgemäßen Verfahrens zur Bestimmung des Wahrheitswerts einer logischen XOR-Verknüpfung, das eine erfindungsgemäße Stapelung von Speicherelementen verwendet: Initialisierung (Teilbild a), Speicherung des Wahrheitswerts (Teilbild b), Auslesen des Wahrheitswerts (Teilbild c).
- Figur 11:: Ausführungsbeispiel eines erfindungsgemäßen resistiven Arbeitsspeichers (RRAM) in perspektivischer Ansicht.
- Figur 12:: Veranschaulichung der Problematik parasitärer Ströme in einer Speichermatrix.
- Figur 13:: Ausführungsbeispiel des 2/3-Spannungsschemas, das die Beeinflussung nicht adressierter Speicherelemente beim Schreiben verhindert.
- Figur 14:: Gemessene I-V-Kennlinie eines erfindungsgemäßen Speicherelements.
- Figur 15:: Beispielhafte Abfolge von Spannungspulsen, die ein Speicherelement in einer Speichermatrix erfährt, und durch das Speicherelement getriebene Ströme. Spannungen und Ströme sind jeweils sowohl für das adressierte als auch für ein nicht adressiertes Speicherelement dargestellt.

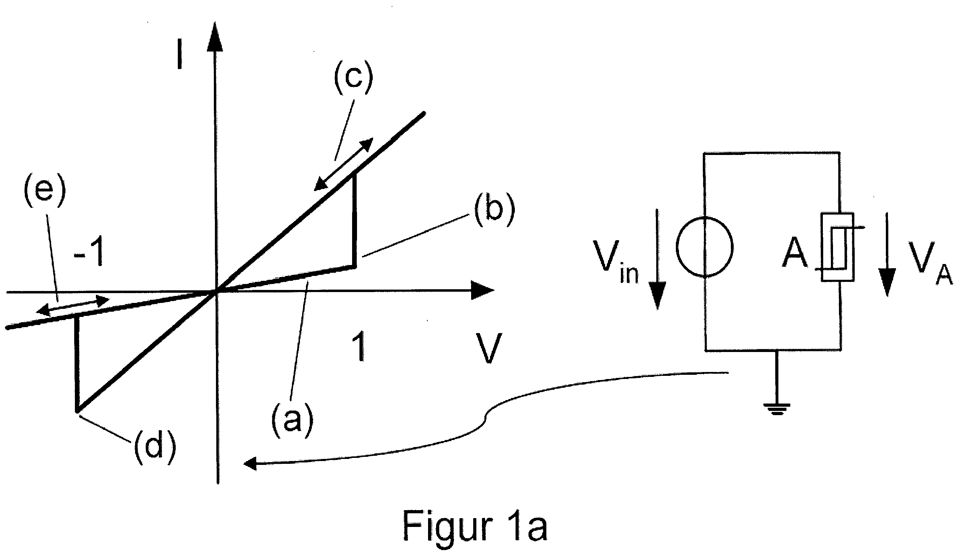

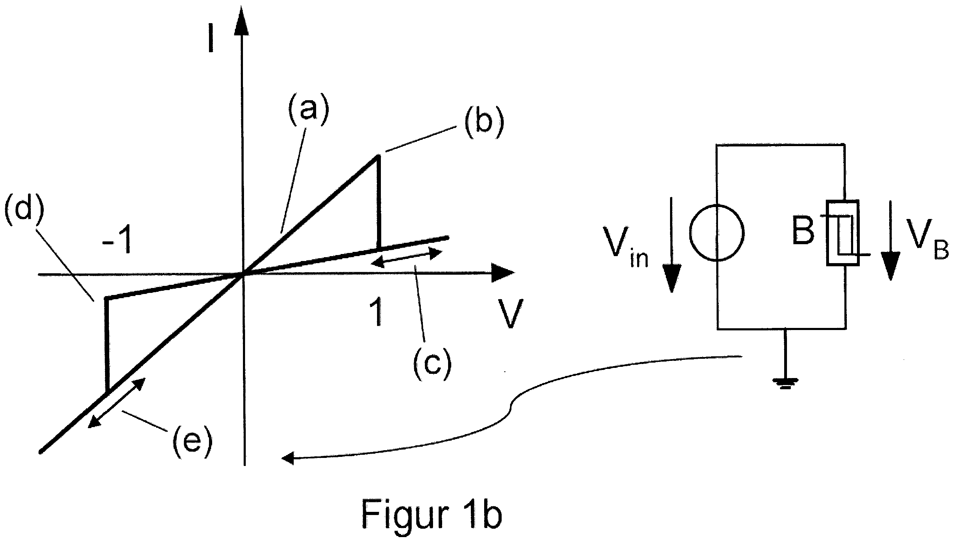

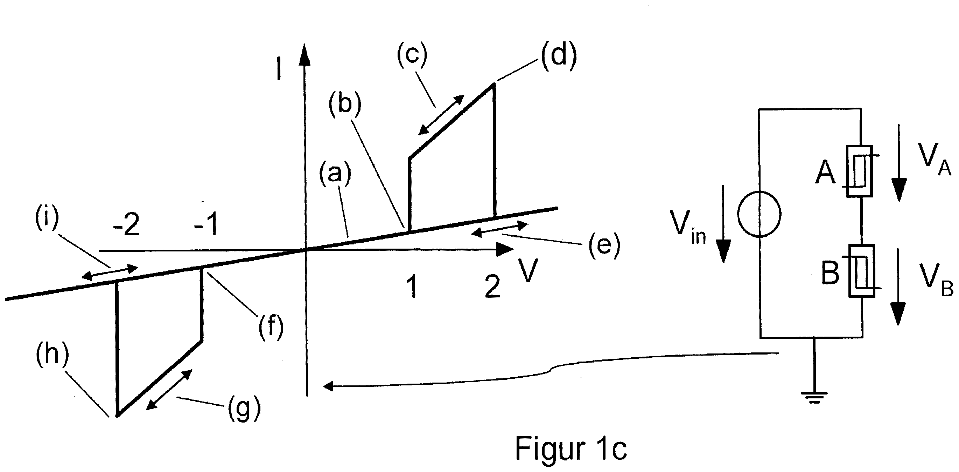

Die Figuren 1 a und 1 b zeigen die Strom (I)-Spannungs (V)-Kennlinien zweier identischer Speicherzellen A und B in willkürlichen Einheiten sowie die jeweiligen Schaltbilder, in denen die jeweiligen Kennlinien erhalten werden. In Bezug auf die angelegte Spannung Vᵢₙ ist die Polung der Speicherzelle B gegenüber der Speicherzelle A umgekehrt. Die Speicherzellen A und B sind bipolar schaltend ausgestaltet. Die Spannung V_{A} beziehungsweise V_{B}, die über den Speicherzellen A und B abfällt, ist jeweils mit der angelegten Spannung Vᵢₙ identisch.

Die in Figur 1 a gezeigte I-V-Kennlinie für die Speicherzelle A geht vom Zustand A0 mit hohem elektrischem Widerstand aus (a). Erreicht die an der Speicherzelle A abfallende Spannung die positive Schaltschwelle, hier 1 (b), so wird die Speicherzelle A in den Zustand A1 versetzt, und ihr elektrischer Widerstand nimmt ab. Die Leitfähigkeit nimmt sprunghaft zu, und die Steigung der I-V-Kennlinie ist bei nun folgenden Änderungen der Spannung erhöht (c). Dies gilt nicht nur, wenn die Spannung weiter erhöht wird, sondern auch, wenn sie wieder unter die positive Schaltschwelle abgesenkt wird oder gar beim Durchgang durch den Ursprung das Vorzeichen wechselt. Erst wenn die Spannung die negative Schaltschwelle, hier
-1 (d), erreicht, wird die Speicherzelle A in den Zustand A0 zurückversetzt. Die Steigung der I-V-Kennlinie nimmt sprunghaft für weitere Änderungen der Spannung V wieder den ursprünglichen Wert an, unabhängig davon, ob diese Änderung in negativer oder in positiver Richtung erfolgt (e).

Die in Figur 1b gezeigte I-V-Kennlinie für die umgekehrt gepolte Speicherzelle B geht vom Zustand B1 mit geringem elektrischem Widerstand aus. Die Steigung der Kennlinie ist hoch (a). Wird die positive Schaltschwelle, hier 1 (b), erreicht, so wird die Speicherzelle B in den Zustand B0 geschaltet. Der Widerstand erhöht sich. Die Steigung der I-V-Kennlinie nimmt für die folgenden Änderungen der Spannung V sprunghaft ab, unabhängig davon, ob die Spannung weiter erhöht oder gesenkt wird (c). Diese geringere Steigung bleibt auch erhalten, wenn die Spannung V beim Durchgang durch den Ursprung das Vorzeichen wechselt. Erst wenn die negative Schaltschwelle, hier -1 (d), erreicht ist, wird die Speicherzelle B in den Zustand B1 zurückgeschaltet. Der Widerstand nimmt ab, die Steigung der I-V-Kennlinie nimmt sprunghaft zu, unabhängig davon, ob die Spannung V im Folgenden in Richtung der negativen oder der positiven V-Achse geändert wird.

Figur 1c zeigt die I-V-Kennlinie für ein Ausführungsbeispiel des erfindungsgemäßen Speicherelements. Dieses Speicherelement umfasst die identischen, antiseriell geschalteten, resistiven Speicherzellen, deren Verhalten als Einzelzellen in den Figuren 1 a und 1 b mit zugehöriger Beschreibung studiert wurde. Figur 1c zeigt auch das zugehörige Schaltbild, in dem die dargestellte Kennlinie erhalten wird. Die angelegte Spannung Vᵢₙ wird durch die erfindungsgemäße Ausgestaltung des Speicherelements als Spannungsteiler nun auf zwei Spannungen V_{A} und V_{B} aufgeteilt, die über die Speicherzellen A und B abfallen. Dabei fällt über die Speicherzelle mit dem höheren Widerstand die größere Spannung ab.

Die Kennlinie beginnt bei der Kombination der Zustände A0 und B1, also im Zustand 1 des Speicherelements (a). Bei einer ersten positiven Schaltschwelle, hier 1 (b), die der minimal benötigten Auslesespannung V_{R} entspricht, wird die Speicherzelle A in den Zustand A1 geschaltet. Da nun beide Speicherzellen einen geringen elektrischen Widerstand aufweisen, ist der Gesamtwiderstand der Serienschaltung sprunghaft erniedrigt und die Steigung der I-V-Kennlinie für die weitere Steigerung der Spannung V erhöht (c). Die Umschaltung der Speicherzelle A in den Zustand A1 ist gegenüber der Umschaltung der Speicherzelle B in den Zustand B0 bevorzugt, weil die Speicherzelle A im Zustand A0 den höheren Widerstand aufweist und daher in dem Spannungsteiler der größte Teil der angelegten Spannung Vᵢₙ über die Speicherzelle A abfällt. Erst wenn die Spannung V eine zweite positive Schaltschwelle, hier 2 (d), erreicht, die der minimal benötigten Schreibspannung V₀ entspricht, wird die Speicherzelle B in den Zustand B0 geschaltet. Der Gesamtwiderstand der Serienschaltung ist nun wieder hoch, und die Steigung der I-V-Kennlinie nimmt für künftige Änderungen der Spannung V wieder sprunghaft ab (e). Das Speicherelement befindet sich im Zustand 0. Analog gibt es zwei negative Schaltschwellen. Bei der ersten negativen Schaltschwelle, hier -1 (f), die der minimal benötigten Auslesespannung V_{R} auf der negativen Achse entspricht, wird Speicherzelle B in den Zustand B1 zurückgeschaltet. Diese Umschaltung ist gegenüber der Umschaltung der Speicherzelle A in den Zustand A0 bevorzugt, da die Speicherzelle B im Zustand B0 den größeren Widerstand aufweist und in dem Spannungsteiler der größte Teil der angelegten Spannung Vᵢₙ über die Speicherzelle B abfällt. Da nun wieder beide Speicherzellen einen geringen Widerstand aufweisen, ist der Gesamtwiderstand erniedrigt; die Leitfähigkeit und damit die Steigung der I-V-Kennlinie steigen sprunghaft an (g). Bei einer zweiten negativen Schaltschwelle (hier -2), die der minimal benötigten Schreibspannung V₁ entspricht, wird Speicherzelle A in den Zustand A0 geschaltet (h). Der Gesamtwiderstand der Serienschaltung nimmt zu, die Leitfähigkeit und damit die Steigung der I-V-Kennlinie nehmen sprunghaft ab (i). Das Speicherelement kehrt insgesamt zurück in den Zustand 1.

Der Bereich zwischen den beiden positiven Schaltschwellen, beziehungsweise zwischen den beiden negativen Schaltschwellen, bildet jeweils das Lesefenster ("read window"). Mit Spannungen in diesem Bereich kann das Speicherelement ausgelesen werden. In der Praxis wird das Lesefenster in der Regel nicht voll ausgenutzt, sondern es wird zur Ober- und Untergrenze jeweils ein Sicherheitsabstand von etwa 10 % eingehalten, um mögliche Streuungen der Schaltschwellen in einer Matrix aus vielen nominell identischen Speicherelementen zu berücksichtigen.

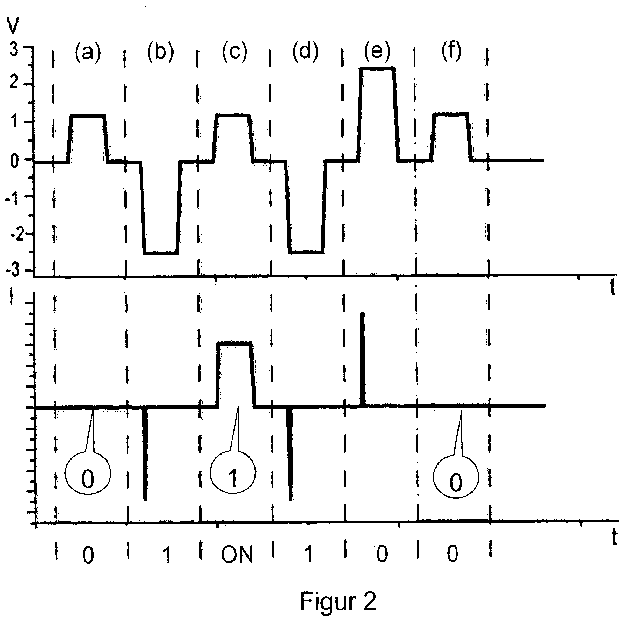

Figur 2 zeigt für das in Figur 1b gezeigte Ausführungsbeispiel des erfindungsgemäßen Speicherelements den Zeitverlauf von Pulsen für verschiedene Operationen sowie den daraus resultierenden Zeitverlauf des durch das Speicherelement fließenden Stroms. Am unteren Rand von Figur 2 ist jeweils angegeben, in welchem Zustand sich das Speicherelement zu welcher Zeit befindet.

Ausgehend vom Zustand 0 wird zunächst ein Puls mit der Auslesespannung V_{R}, hier 1, gegeben (a). Da Zustand 0 in der Zustandskombination A1 und B0 kodiert ist, ändert dieser Puls nichts an der Konfiguration der Speicherzellen. Daher führt dieser Puls auch nicht zu einer Änderung des Stroms. Eine 0 ist ausgelesen worden.

Als Nächstes wird ein Puls mit der Schreibspannung V₁, hier-2,5, gegeben (b). Dabei wird die Speicherzelle A in den Zustand A0 geschaltet, und die Speicherzelle B wird in den Zustand B1 geschaltet. Dies zeigt sich in einem kurzen Spike des Stroms durch das Speicherelement. Nachdem das Umschalten abgeschlossen ist, befindet sich das Speicherelement im Zustand 1, und der Strom nimmt wieder den ursprünglichen Wert an. Der Spike liefert die Information, dass das Speicherelement vor dem Schreiben im Zustand 0 war und dass das Umschalten in den Zustand 1 erfolgreich war.

Ein anschließend gegebener Puls mit der Auslesespannung V_{R} (c) schaltet die Speicherzelle A in den Zustand A1. Da sich nun beide Speicherzellen im Zustand geringen Widerstands befinden, fließt für die Dauer des Pulses ein gut detektierbarer Lesestrom (Zustand "ON"). Eine 1 ist ausgelesen worden.

Da das Speicherelement durch das Auslesen den Zustand 1 verlassen hat, wird dieser als Nächstes durch einen erneuten Puls mit der Schreibspannung V₁ (d) zurück in das Speicherelement geschrieben. Es zeigt sich erneut ein kurzer Spike im Strom, da die Speicherzelle A vom Zustand A1 zurück in den Zustand A0 geschaltet wird.

Als Nächstes wird ein Puls mit der Schreibspannung V₀, hier +2,5, angelegt (e). Analog zum Schreiben einer 1 zeigt sich ein kurzer Spike im Strom (mit umgekehrter Polarität) während der Umschaltung von A0 nach A1 und von B1 nach B0.

Ein anschließender Puls mit der Auslesespannung V_{R} (f) ändert nichts an der Konfiguration der Speicherzellen A und B und führt daher auch nicht zu einer Änderung des Stroms durch das Speicherelement. Eine 0 ist ausgelesen worden.

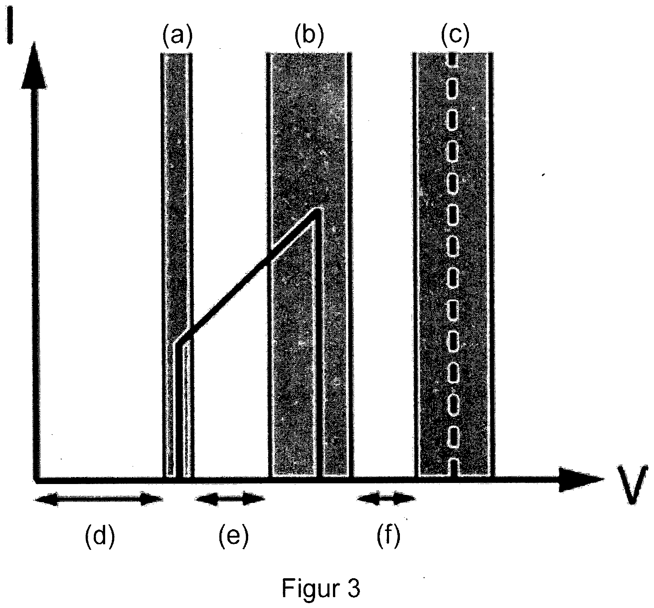

Figur 3 verdeutlicht eine Worst-case-Abschätzung, welche Schwankungsbreite in den Schaltspannungen und Widerstandswerten der einzelnen Speicherzellen tolerabel ist. Dies ist insbesondere für Speichermatrizen aus sehr vielen nominell identischen Speicherelementen relevant.

In Figur 3 ist in einem Ausschnitt aus der I-V-Kennlinie des in Figur 1b gezeigten Ausführungsbeispiels eingezeichnet, wie sich eine Streuung in den Schaltspannungen und Widerstandswerten der Speicherzellen A und B von bis zu ± 10 % auf die Streuung der ersten und der zweiten positiven Schaltschwelle sowie der Zerstörschwelle des Speicherelements fortpflanzt. Es sind diejenigen Bereiche markiert, in denen die erste positive Schaltschwelle (a), die zweite positive Schaltschwelle (b) und die Zerstörschwelle (c) auf Grund der angenommenen Streuung von ± 10 % in den Parametern der Speicherzellen jeweils streuen kann. Unter der V-Achse sind jeweils die Fenster angegeben, die unter Berücksichtigung dieser Streuungen für die höchstzulässige, an einem nicht adressierten Speicherelement anliegende Spannung (d), für die Auslesespannung V_{R} (e) sowie für die Schreibspannung V₀ (f) verbleiben. Da für alle drei Parameter ausreichend große und nicht überlappende Fenster verbleiben, ist eine Streuung von bis zu ± 10 % in den Kenngrößen der einzelnen Speicherzellen durchaus tolerabel.

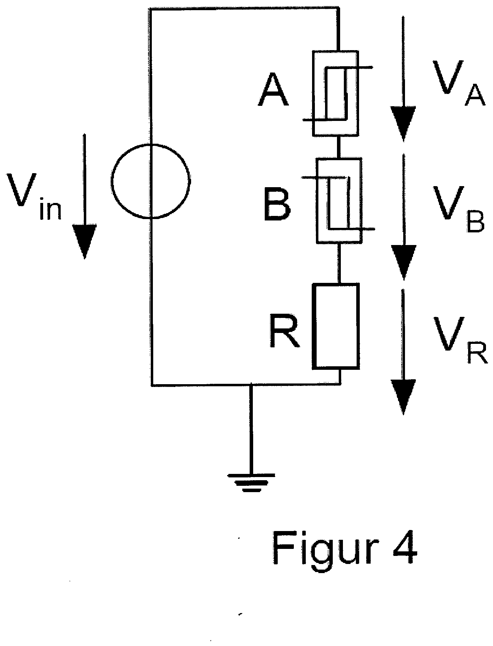

In Figur 4 ist ein Ausführungsbeispiel des erfindungsgemäßen Speicherelements mit einem weiteren Widerstand R, der mit den Speicherzellen A und B in Serie geschaltet ist, skizziert. Die I-V-Kennlinie einschließlich der Schaltschwellen entspricht der in Figur 1c gezeigten Kennlinie. Selbst wenn die Kennlinien der Speicherzellen A und B, anders als in den Figuren 1 a und 1 b dargestellt, nicht symmetrisch um den Ursprung sind, kann durch den erfindungsgemäß vorgesehenen weiteren Widerstand für das Speicherelement als Ganzes noch eine um den Ursprung symmetrische Kennlinie erzielt werden. Der weitere Widerstand R im Spannungsteiler bewirkt durch die über ihn abfallende Spannung V_{R}, dass in der Kombination der Zustände A1 und B1 gleiche Spannungen V_{A} und V_{B} über die Speicherzellen A und B abfallen. In dem Ausführungsbeispiel ist der Widerstandswert von R siebenmal so groß wie die Widerstandswerte der Speicherzellen A und B in den Zuständen A1 und B1.

Je symmetrischer die Kennlinie um den Ursprung ist, desto größer ist das Lesefenster für die Auslesespannung V_{R}.

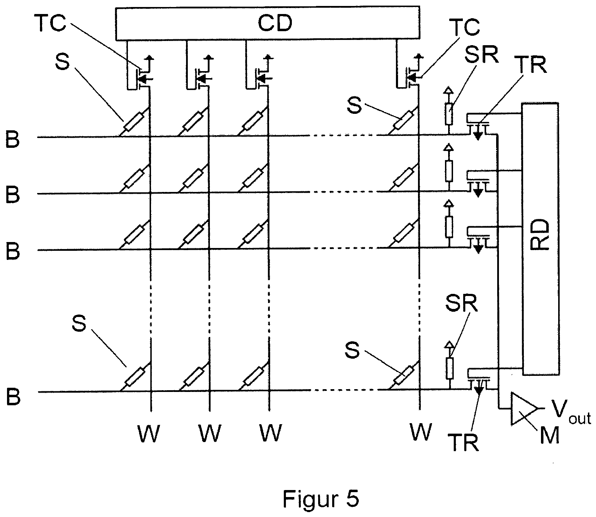

In Figur 5 ist ein Ausführungsbeispiel einer erfindungsgemäßen Speichermatrix skizziert. Diese Speichermatrix enthält keine aktiven Schaltelemente, die unabhängig vom Strom durch die Wordlines W oder die Bitlines B angesteuert werden können. Die Wordlines W verlaufen senkrecht, die Bitlines B verlaufen waagerecht. Zwischen eine Wordline W und eine Bitline B ist jeweils ein erfindungsgemäßes Speicherelement S geschaltet. Jede Wordline W kann von einem Spaltendekoder CD über einen ihr zugeordneten Transistor TC mit einer Spannung beaufschlagt werden. Jede Bitline B kann von einem Zeilendekoder RD über einen ihr zugeordneten Transistor TR mit einer Spannung beaufschlagt werden. Jede Bitline B ist über einen Pull-Up-Widerstand SR mit der Versorgungsspannung V_{DD} verbunden. Sofern eine Bitline B über den ihr zugeordneten Transistor TR mit einer Spannung beaufschlagt wird, stellt dieser Transistor gleichzeitig auch eine Verbindung zwischen dieser Bitline B und einem Spannungsmessgerät M her, das eine Ausgangsspannung Vₒᵤₜ liefert.

Zu einer gegebenen Zeit werden immer nur eine Wordline W und eine Bitline B durch die Dekoder CD und RD angesteuert. Damit wird genau das zwischen diese Wordline W und diese Bitline B geschaltete Speicherelement S adressiert. Die an die Wordline W und die Bitline B angelegten Spannungen werden dabei so gewählt, dass am adressierten Speicherelement S insgesamt die Auslesespannung V_{R} anliegt. Befindet sich dieses Speicherelement S im Zustand 0, so bewirkt nur die an die angesteuerte Bitline B angelegte Spannung einen Stromfluss durch den Sensorwiderstand SR dieser Bitline B und damit einen Spannungsabfall an diesem Sensorwiderstand SR. Dieser Spannungsabfall wird vom Spannungsmessgerät M registriert. Befindet sich das Speicherelement S dagegen im Zustand 1, so wird es durch die Auslesespannung VR insgesamt in den Zustand ON mit geringem Widerstand versetzt. Der daraufhin durch das Speicherelement fließende Lesestrom bewirkt einen zusätzlichen Spannungsabfall am der Bitline B zugeordneten Sensorwiderstand SR, der vom Spannungsmessgerät M registriert wird.

Es können aber durchaus auch mehrere oder sogar alle Word- bzw. Bitlines gleichzeitig angesteuert werden. Dadurch kann die Information blockweise in die Speichermatrix hinein- bzw. aus ihr heraustransferiert werden, was den Datendurchsatz erhöht.

Parasitäre Ströme durch nicht adressierte Speicherelemente S werden durch die erfindungsgemäße Ausgestaltung der Speicherelemente vorteilhaft minimiert. Sie können jedoch nicht vollständig zum Verschwinden gebracht werden. Jeder parasitäre Strom fließt ebenfalls über den Sensorwiderstand SR und liefert daher einen zusätzlichen Beitrag zum Spannungsabfall über diesem Sensorwiderstand, der vom Spannungsmessgerät M registriert wird. Daher gibt es eine endliche Anzahl Speicherelemente S , ab der sich die Spannungen, die das Spannungsmessgerät M beim Auslesen einer 0 beziehungsweise einer 1 aus dem adressierten Speicherelement S registriert, nicht mehr sicher voneinander unterscheiden lassen.

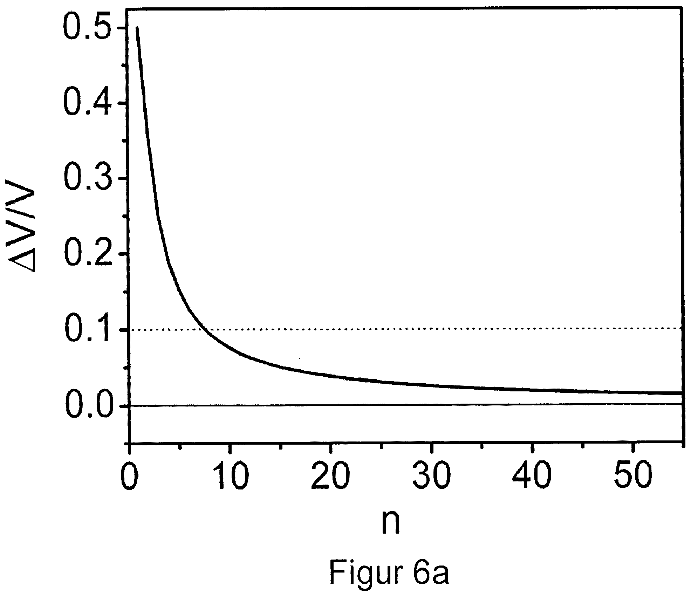

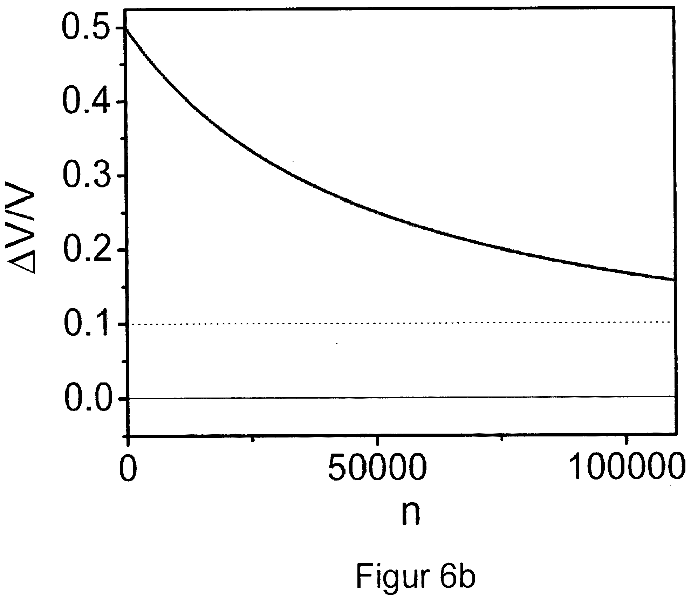

In Figur 6a ist für eine Speichermatrix mit resistiven Speicherelementen nach dem Stand der Technik, die nur aus einer Speicherzelle bestehen, und in Figur 6b für die erfindungsgemäße Speichermatrix jeweils das Verhältnis ΔV/V des Spannungshubs zwischen den beim Auslesen einer 0 und beim Auslesen einer 1 vom Spannungsmessgerät M registrierten Spannungen Vₒᵤₜ und der Betriebsspannung der Speichermatrix in Abhängigkeit der Anzahl n der Speicherelemente in der Speichermatrix aufgetragen. Welches Verhältnis ΔV für ein technisch sicheres Auslesen erforderlich ist und welche Maximalzahl Speicherelemente die Speichermatrix aufweisen darf, damit diese Anforderung gerade noch erfüllt ist, hängt davon ab, wie aufwändig das Spannungsmessgerät M ausgeführt ist.

Selbst wenn nur ein Spannungshub ΔV von 10 % der Betriebsspannung gefordert wird, was beim derzeitigen Stand der Technik in der Analogelektronik keine große Herausforderung mehr darstellt, stößt die Speichermatrix nach dem Stand der Technik schon bei einer Größe von nur 8 Speicherelementen an diese, in den Figuren 6a und 6b als gepunktete Linie eingezeichnete, Grenze. Dagegen befindet sich in der erfindungsgemäßen Speichermatrix der Spannungshub auch bei 100.000 vorhandenen Speicherelementen noch weit oberhalb der Schwelle von
10 %. Damit stößt die erfindungsgemäße Speichermatrix in die für die Datenverarbeitung relevanten Dimensionen vor.

Für eine Speichermatrix aus 512x512 Speicherelementen kann ein Spannungshub von 86,7 % der Versorgungsspannung erzielt werden, wenn die Speicherelemente typischerweise im Zustand hohen elektrischen Widerstands einen Widerstandswert von 10⁸ Ω und im Zustand niedrigen elektrischen Widerstands einen Widerstandswert von 2 kΩ haben.

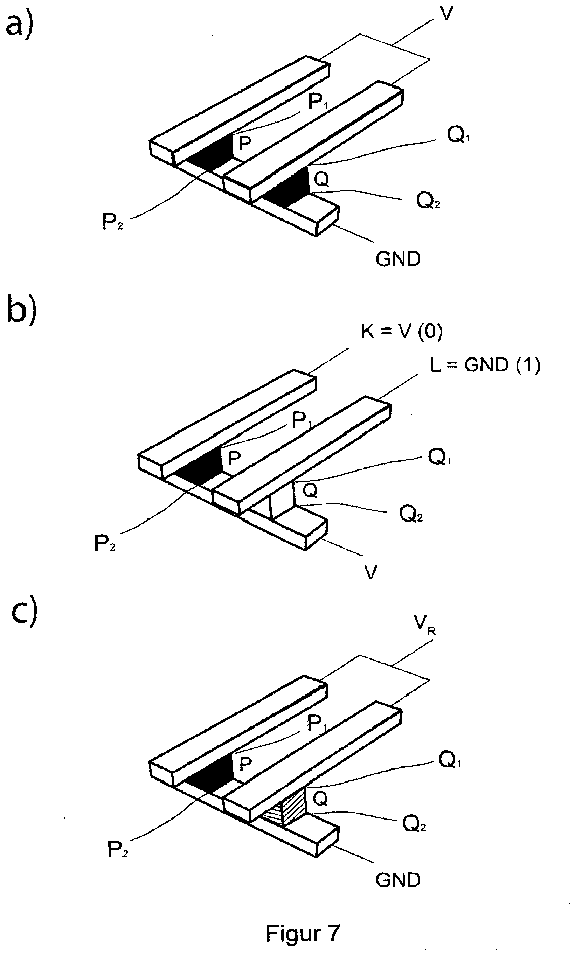

Figur 7 verdeutlicht ein Ausführungsbeispiel des erfindungsgemäßen Verfahrens zur Bestimmung des Wahrheitswerts einer logischen Verknüpfung. Es wird eine Anordnung aus zwei erfindungsgemäßen Speicherelementen P und Q verwendet. Das Speicherelement P hat die Pole P₁ und P₂, die für eine Beschaltung zugänglich sind. Das Speicherelement Q hat die Pole Q₁ und Q₂. Die Färbung jedes der Speicherelemente P und Q gibt den Zustand an, in dem sich das Speicherelement befindet. Eine dunkle Färbung entspricht dem Zustand 0, eine helle Färbung entspricht dem Zustand 1, und eine helle Färbung mit Schraffur entspricht dem Zustand ON.

Die Zuordnung der Pole P₁ und P₂ bzw. Q₁ und Q₂ ist ohne Beschränkung der Allgemeinheit so gewählt, dass eine Schreibspannung V₀, die das Potential am Pol P₁ gegenüber dem Potential am Pol P₂ erhöht, das Speicherelement P vom Zustand 1 in den Zustand 0 schaltet. Analog schaltet eine Schreibspannung V₀, die das Potential am Pol Q₁ gegenüber dem Potential am Pol Q₂ erhöht, das Speicherelement Q vom Zustand 1 in den Zustand 0.

Figur 7a verdeutlicht, wie die Anordnung initialisiert wird. Beide Speicherelemente P und Q werden jeweils in den Zustand 0 initialisiert, indem ihre Pole P₁ und Q₁ auf das Potential V sowie ihre Pole P₂ und Q₂ auf das Massepotential GND gebracht werden. Das Potential an den Polen P₁ und Q₁ ist somit gegenüber dem Potential an den Polen P₂ und Q₂ erhöht. Eine Potentialdifferenz mit dieser Polarität schaltet beide Speicherzellen P und Q in den Zustand 0.

Figur 7b zeigt, wie anschließend der Wahrheitswert der logischen Verknüpfung von zwei Variablen K und L in der Anordnung gespeichert wird. K hat in diesem Beispiel den Wahrheitswert 0, dem das Potential V als Spannungspegel zugeordnet ist. L hat den Wahrheitswert 1, dem das Massepotential GND als Spannungspegel zugeordnet ist. An den Polen P₂ und Q₂ liegt das Potential V an. Über dem Speicherelement P fällt keine Spannung ab, da an beiden Polen P₁ und P₂ das gleiche Potential anliegt. Das Speicherelement P bleibt im Zustand 0. Über dem Speicherelement Q fällt dagegen von Q₂ nach Q₁ die Schreibspannung V gegen Masse ab. Das Speicherelement Q wird hierdurch in den Zustand 1 umgeschaltet. In den nun vorliegenden Zuständen 0 bzw. 1 der Speicherelemente P und Q ist der Wahrheitswert 1 der Verknüpfung "K ODER L" verkörpert.

Figur 7c zeigt, wie dieser Wahrheitswert anschließend aus der Anordnung ausgelesen wird. An die Pole P₁ und Q₁ wird eine Auslesespannung V_{R} gegen die auf Massepotential GND befindlichen Pole P₂ und Q₂ angelegt. Diese Auslesespannung V_{R} liegt innerhalb des positiven Lesefensters der Speicherelemente P und Q (vergleiche Figur 1 c). Dies ändert am Zustand des Speicherelements P, das sich im Zustand 0 befindet, nichts. Speicherelement Q, das sich im Zustand 1 befindet, wird dagegen in den Zustand ON umgeschaltet. Durch das Speicherelement Q, und damit durch die Parallelschaltung, fließt ein gut detektierbarer Lesestrom. Dieser Lesestrom zeigt an, dass der in der Anordnung gespeicherte Wahrheitswert 1 war.

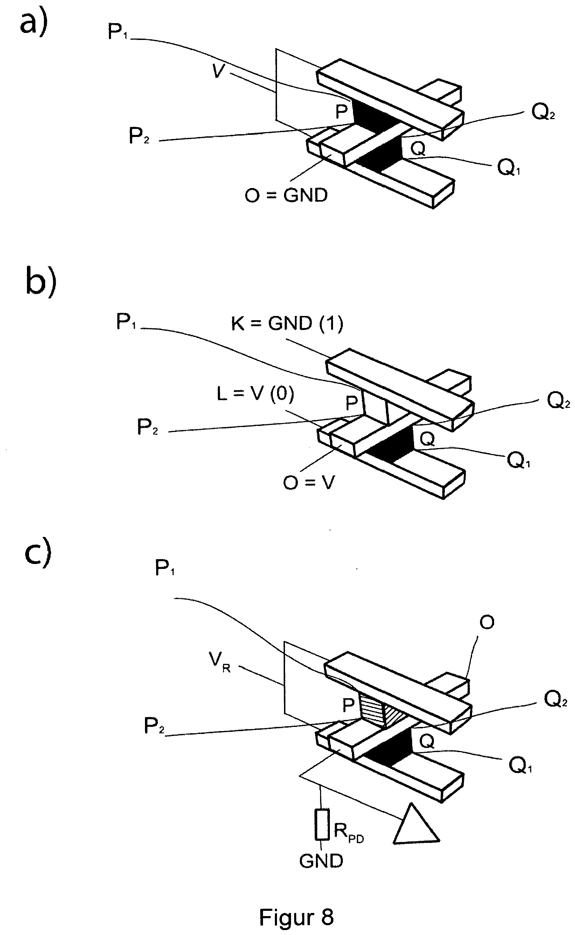

Figur 8 zeigt ein weiteres Ausführungsbeispiel, in dem der Wahrheitswert der logischen Verknüpfung "K ODER L" bestimmt wird. Der Unterschied zu dem in Figur 7 gezeigten Ausführungsbeispiel liegt darin, dass an Stelle zweier nebeneinander angeordneter Speicherelemente P und Q eine erfindungsgemäße Stapelung ebendieser Speicherelemente P und Q verwendet wird. Bezugszeichen, die auch in Figur 7 verwendet werden, bezeichnen Teile, die gleich wirken wie die entsprechenden in Figur 7 gezeigten Teile.

In Figur 8a ist gezeigt, wie beide Speicherelemente P und Q initialisiert werden. Dazu wird an die Pole P₁ und Q₁ das Potential V angelegt. Die Pole P₂ und Q₂ sind über einen elektrischen Kontakt O verbunden, der mit dem Massepotential GND beaufschlagt ist. Die Spannung V fällt sowohl über das Speicherelement P als auch über das Speicherelement Q ab, und zwar von P₁ nach P₂ sowie von Q₁ nach Q₂. Sie wirkt daher sowohl auf das Speicherelement P als auch auf das Speicherelement Q als Schreibspannung V₀. Beide Speicherzellen P und Q werden somit in den Zustand 0 initialisiert.

Figur 8b zeigt, wie der Wahrheitswert der Verknüpfung "K ODER L" in diesem Ausführungsbeispiel bestimmt wird. K hat in diesem Beispiel den Wahrheitswert 1, dem das Massepotential GND als Spannungspegel zugeordnet ist. L hat den Wahrheitswert 0, dem das Potential V als Spannungspegel zugeordnet ist. Über dem Speicherelement P fällt die Spannung V von P₂ nach P₁ ab, so dass dieses Speicherelement in den Zustand 1 umgeschaltet wird. Über dem Speicherelement Q fällt keine Spannung ab. Sein Zustand bleibt unverändert auf 0. In den nun vorliegenden Zuständen 1 bzw. 0 der Speicherelemente P und Q ist der Wahrheitswert 1 der Verknüpfung "K ODER L" verkörpert.

Figur 8c zeigt, wie dieses Ergebnis aus der Anordnung ausgelesen wird. Beide Speicherelemente P und Q werden mit einer Auslesespannung V_{R}, die innerhalb des positiven Lesefensters der Speicherelemente P und Q liegt (vergleiche Figur 1 c), beaufschlagt. Hierzu wird das Massepotential GND an den Kontakt O angelegt, über den die Speicherelemente P und Q miteinander verbunden sind. Damit befinden sich die Pole P₂ und Q₂ auf dem Massepotential GND. Die Pole P₁ und Q₁ werden dagegen auf das Potential V_{R} gelegt. Der Spannungsabfall V_{R} von P₁ nach P₂ versetzt das in den Zustand 1 umgeschaltete Speicherelement P in den Zustand ON und macht es niederohmig. Durch dieses Speicherelement fließt ein gut detektierbarer Lesestrom. Dieser Lesestrom bewirkt über dem gegen Masse geschalteten Widerstand R_{PD} einen Spannungsabfall, der mit dem eingezeichneten Operationsverstärker detektiert werden kann.

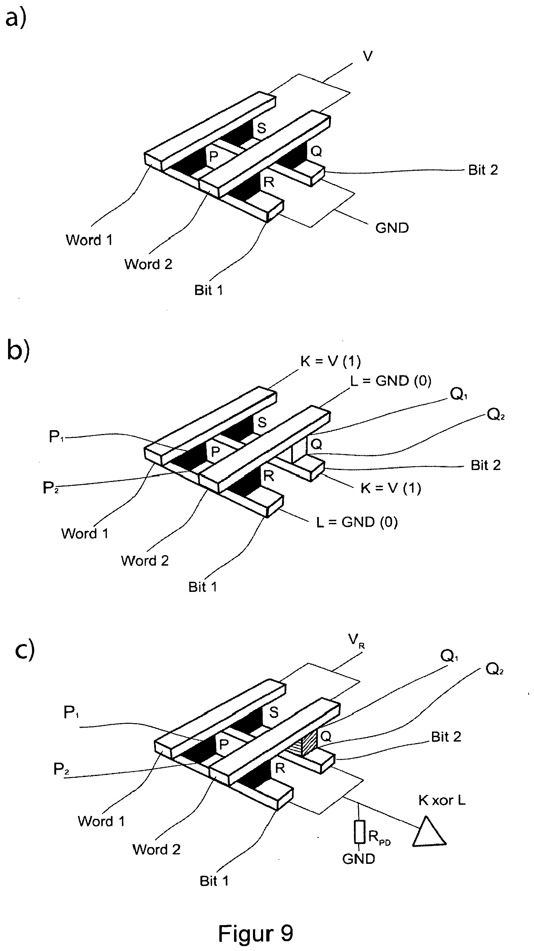

Figur 9 zeigt ein Ausführungsbeispiel des erfindungsgemäßen Verfahren zur Bestimmung des Wahrheitswerts einer logischen Verknüpfung zweier Variablen K und L, das eine erfindungsgemäße Speichermatrix als Anordnung aus Speicherelementen verwendet. Die Speichermatrix umfasst zwei Wordlines Word1 und Word2 sowie Bitlines Bit1 und Bit2, die die Wordlines kreuzen. Die sich kreuzenden Word- und Bitlines sind an den Kreuzungspunkten durch vier erfindungsgemäße Speicherelemente P, Q_{,} R und S miteinander verbunden.

In Figur 9a ist gezeigt, wie alle vier Speicherelemente P, Q, R und S in den Zustand 0 initialisiert werden. Eine Spannung V, die auf alle vier Speicherelemente als Schreibspannung V₀ wirkt, wird an beide Wordlines angelegt, während beide Bitlines mit dem Massepotential verbunden werden.

Figur 9b zeigt, wie der Wahrheitswert der Verknüpfung "K XOR L" in der Speichermatrix gespeichert wird. K hat in diesem Beispiel den Wahrheitswert 1, dem die Spannung V als Spannungspegel zugeordnet ist. L hat den Wahrheitswert 0, dem das Massepotential (GND) als Spannungspegel zugeordnet ist. Die Wordline Word1 und die Bitline Bit2 werden nun mit dem Spannungspegel von K (V) beaufschlagt, der somit am Pol P₁ des Speicherelements P und am Pol Q₂ des Speicherelements Q anliegt. Die Wordline Word2 und die Bitline Bit1 werden mit dem Spannungspegel von L (GND) beaufschlagt, der somit am Pol P₂ des Speicherelements P und am Pol Q₁ des Speicherelements Q anliegt.

Der Spannungsabfall V über dem Speicherelement P von P₁ nach P₂ ist der gleiche wie zuvor bei der Initialisierung. Er wirkt auf das Speicherelement P somit als Schreibspannung V₀. Der Zustand des Speicherelements P bleibt somit unverändert 0. Das Speicherelement Q dagegen wird mit einem entgegengesetzt gepolten Spannungsabfall von Q₂ nach Q₁ beaufschlagt. Dieser Spannungsabfall wirkt auf das Speicherelement Q als Schreibspannung V₁. Das Speicherelement Q wird somit in den Zustand 1 umgeschaltet. In den nun vorliegenden Zuständen 0 bzw. 1 der Speicherelemente P und Q ist der Wahrheitswert 1 der Verknüpfung "K XOR L" verkörpert.

Figur 9c zeigt, wie dieser Wahrheitswert aus der Speichermatrix ausgelesen wird. Beide Wordlines werden mit einer Auslesespannung V_{R} beaufschlagt, die innerhalb des positiven Lesefensters der Speicherelemente P und Q liegt. Diese Auslesespannung V_{R} schaltet das Speicherelement Q₁ das sich im Zustand 1 befindet, weiter in den Zustand ON. Das Speicherelement Q wird somit niederohmig.

Der aus beiden Bitlines durch den Widerstand R_{PD} gegen Masse fließende Strom verursacht an diesem Widerstand einen Spannungsabfall, der mit dem eingezeichneten Operationsverstärker gemessen wird. Für den Strom gibt es einen niederohmigen Pfad durch das Speicherelement Q, das sich im Zustand ON befindet. Es fließt daher ein gut detektierbarer Lesestrom, der den Wahrheitswert 1 anzeigt.

Die Speicherelemente R und S haben in diesem Beispiel keine Funktion. Beim Speichern des Wahrheitswerts "K XOR L" in der Speichermatrix liegt L an beiden Polen des Speicherelements R an, und K liegt an beiden Polen des Speicherelements S an. Nach der Initialisierung auf 0 sehen die Speicherelemente R und S somit keinen Spannungsabfall mehr, der für eine Umschaltung in den Zustand 1 ausreichen könnte. Werden nun aber L statt K an die Wordline Word1 und K statt L an die Wordline Word2 angelegt, oder werden stattdessen K statt L an die Bitline Bit1 und L statt K an die Bitline Bit2 angelegt, so treten die Speicherelemente P und Q außer Funktion, und die Speicherung des Wahrheitswerts wird von den Speicherelementen R und S übernommen. Dies kann genutzt werden, um bei einem Ausfall eines der Speicherelemente P oder Q die Arbeit mit den verbleibenden Speicherelementen R und S fortzusetzen.

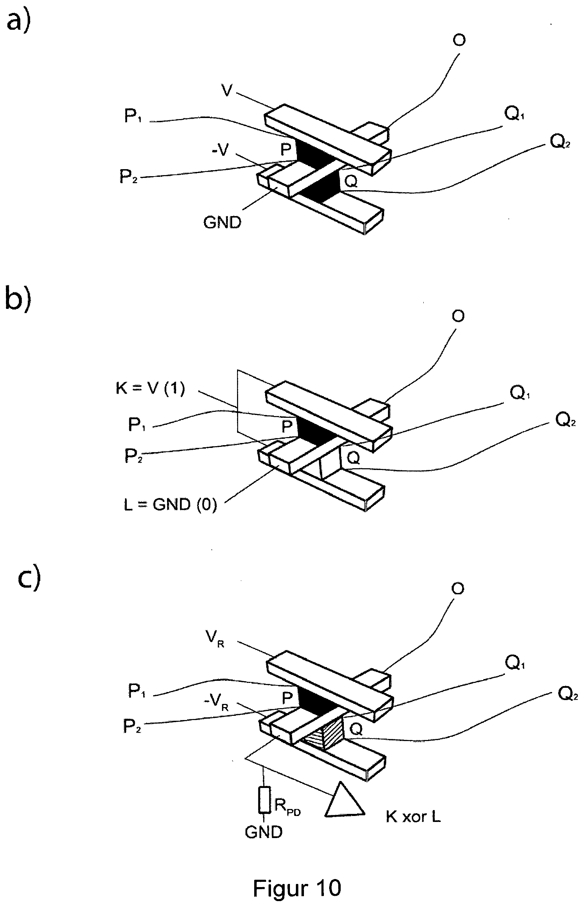

Figur 10 zeigt ein weiteres Ausführungsbeispiel zur Bestimmung des Wahrheitswerts der logischen Verknüpfung "K XOR L". Dieses Ausführungsbeispiel verwendet, analog dem in Figur 8 gezeigten Ausführungsbeispiel, eine erfindungsgemäße Stapelung zweier Speicherelemente P und Q als Anordnung.

Figur 10a zeigt, wie beide Speicherelemente P und Q in den Zustand 0 initialisiert werden. Der elektrische Kontakt O, der den Pol P₂ des Speicherelements P mit dem Pol Q₁ des Speicherelements Q verbindet, wird mit dem Massepotential (GND) beaufschlagt. P₁ wird nun auf das Potential V gebracht, und Q₂ wird auf das Potential -V gebracht. Sowohl in der Speicherzelle P als auch in der Speicherzelle Q steigt somit das Potential vom Pol P₂ bzw. Q₂ hin zum Kontakt P₁ bzw. Q₁ um den Betrag V an. Dies wirkt auf beide Speicherelemente P und Q als Schreibspannung V₀, die beide Speicherelemente in den Zustand 0 initialisiert.

Figur 10b zeigt, wie der Wahrheitswert der Verknüpfung "K XOR L" in der Stapelung gespeichert wird. P₁ und Q₂ werden jeweils mit dem Spannungspegel der Variablen K beaufschlagt. K hat in diesem Beispiel den Wahrheitswert 1, dem die Spannung V als Spannungspegel zugeordnet ist. Der Kontakt O wird mit dem Spannungspegel der Variablen L beaufschlagt. L hat in diesem Beispiel den Wahrheitswert 0, dem das Massepotential (GND) als Spannungspegel zugeordnet ist.

Von P₂ nach P₁ steigt das Potential wie auch bei der Initialisierung um den Betrag V an. Auf das Speicherelement P wirkt somit nach wie vor die Schreibspannung V₀, so dass P im Zustand 0 bleibt. Über dem Speicherelement Q fällt eine betragsmäßig gleiche, aber entgegengesetzt gepolte Spannung ab. Das Potential steigt nun von Q₁ nach Q₂ um den Betrag V an.

Dies ist gleichbedeutend mit einem Spannungsabfall von Q₂ nach Q₁ um den gleichen Betrag und wirkt daher auf das Speicherelement Q als Schreibspannung Q wird in den Zustand 1 umgeschaltet. Der Wahrheitswert 1 der Verknüpfung "K XOR L" ist in den nun vorliegenden Zuständen 0 bzw. 1 der Speicherelemente P und Q kodiert.

Figur 10c zeigt, wie dieser Wahrheitswert aus der Stapelung ausgelesen wird. Das Speicherelement P wird mit einem Potentialanstieg um den Betrag V_{R}, der im Bereich des positiven Lesefensters liegt, von P₂ nach P₁ beaufschlagt. Dies ändert nichts daran, dass sich P im Zustand 0 befindet. Das Speicherelement Q wird durch das Anlegen von -V_{R} an Q₂ mit einem Potentialanstieg um den Betrag V_{R} von Q₂ nach Q₁ beaufschlagt. Da sich das Speicherelement Q im Zustand 1 befindet, wird es in den Zustand ON weitergeschaltet und somit niederohmig. Durch das Speicherelement Q fließt somit ein gut detektierbarer Lesestrom, der über den am Widerstand R_{PD} gegen Masse bewirkten Spannungsabfall mit dem Operationsverstärker gemessen werden kann. Der Lesestrom verkörpert den ausgelesenen Wahrheitswert 1 der Verknüpfung.

Die Zuordnung der Spannungspegel zu den Wahrheitswerten der Variablen K und L ist in den Figuren 9 und 10 gegenüber den Figuren 7 und 8 vertauscht. In den Figuren 7 und 8 ist dem Wahrheitswert 0 das Potential V zugeordnet, und dem Wahrheitswert 1 ist das Massepotential GND zugeordnet. Dies hat vorteilhaft zur Folge, dass nur mit positiven Spannungen, und damit auch nur mit positiven Spannungsquellen, gearbeitet werden muss.

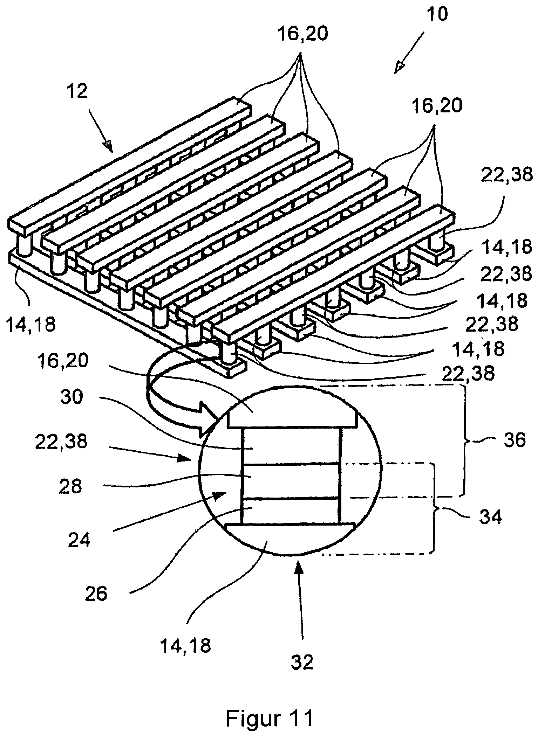

Figur 11 zeigt ein Ausführungsbeispiel eines erfindungsgemäßen resistiven Arbeitsspeichers (RRAM) 10 in perspektivischer Ansicht. Der Arbeitsspeicher 10 enthält eine erfindungsgemäße Speichermatrix 12 mit sich kreuzenden Word- und Bitlines. Die Wordlines 14 sind streifenförmig und wurden in regelmäßigen Abständen zueinander auf einem in Figur 11 nicht eingezeichneten Substrat hergestellt. Die ebenfalls streifenförmigen Bitlines 16 wurden in regelmäßigen Abständen zueinander auf einer zweiten Ebene hergestellt, die sich in einem vorgegebenen Abstand zu der ersten Ebene befindet, in der die Wordlines 14 liegen. In den Speicherelementen 22, die sich an den Kreuzungspunkten zwischen den Wordlines 14 und den Bitlines 16 befinden, sind die Wordlines 14 jeweils die erste Elektrode 18, und die Bitlines sind jeweils die zweite Elektrode 20. Jedes der Speicherelemente 22 enthält eine Stapelung aus Schichten 26, 28 und 30 zwischen seinen Elektroden 18 und 20.

In einer Ausführungsform der Erfindung ist die erste Elektrode 18 inert (etwa Platin). Die erste Schicht 26 auf der ersten Elektrode 18 ist eine erste Schicht aktiven Materials (etwa Germaniumselenid GeSe). Die zweite Schicht 28 auf der ersten Schicht 26 ist eine elektrochemisch aktive Elektrode (etwa Kupfer). Die dritte Schicht 30 auf der zweiten Schicht 28 ist eine zweite Schicht aktiven Materials (etwa eine weitere Schicht aus Germaniumselenid Ge-Se). Die zweite Elektrode 20 auf der dritten Schicht ist wieder eine inerte Elektrode (etwa Platin).

In einer weiteren Ausführungsform der Erfindung ist eine andere Schichtfolge vorgesehen. Die erste Elektrode 18 ist eine elektrochemisch aktive Elektrode (etwa Kupfer). Die erste Schicht 26 auf der ersten Elektrode 18 ist eine erste Schicht aktiven Materials (etwa Germaniumselenid). Die zweite Schicht 28 auf der ersten Schicht 26 ist eine inerte Elektrode (etwa Platin). Die dritte Schicht 30 auf der zweiten Schicht 28 ist eine zweite Schicht aktiven Materials (etwa Germaniumselenid). Die zweite Elektrode 20 auf der dritten Schicht ist eine elektrochemisch aktive Elektrode (etwa Kupfer).

In beiden Ausführungsformen kann die Schichtstapelung in den resistiven Speicherelementen 22 im Ersatzschaltbild als Reihenschaltung 32 angesehen werden, die zwei mindestens funktionell identische Speicherzellen 34, 36 umfasst, wie rechts in Figur 1c dargestellt. Diese beiden resistiven Speicherzellen 34 und 36 sind in Reihe geschaltet, aber elektrisch antiparallel zueinander orientiert. Sie sind antiseriell verschaltet. Die erste Speicherzelle 34 umfasst die erste Elektrode 18, die erste Schicht 26 und die zweite Schicht 28. Die zweite Speicherzelle 36 umfasst die zweite Schicht 28, die dritte Schicht 30 und die zweite Elektrode 20. Jedes Speicherelement 22 ist ein passives bipolar schaltendes resistives Speicherelement 38, das außer den Speicherzellen keine weiteren aktiven Schaltelemente enthält.

Jedes Speicherelement 22 ist auf jeden Fall im Zustand hohen elektrischen Widerstands, wenn es entweder gar nicht mit Spannung beaufschlagt wird oder wenn es mit einer Schreibspannung beaufschlagt wird.

Die Speichermatrix ist vorzugsweise als Hybridlösung aus CMOS-Technologie und Nanoelektronik realisiert. Dazu wird die nanoelektronische Speichermatrix auf einen CMOS-Logikschaltkreis aufgesetzt. Was den Flächenverbrauch und die Skalierbarkeit angeht, so ist die passive Speichermatrix mit sich kreuzenden Word- und Bitlines die effektivste Möglichkeit, einen nanoelektronischen Speicher zu realisieren. Jeder Kreuzungspunkt 24 einer Wordline 14 und einer Bitline 16 bildet ein Speicherelement 22 mit minimaler Zellgröße 4 F², worin F die minimale Featuregröße ist. Das Fehlen aktiver Schaltelemente mit Ausnahme der Speicherzellen selbst macht die Speichermatrix komplett passiv.

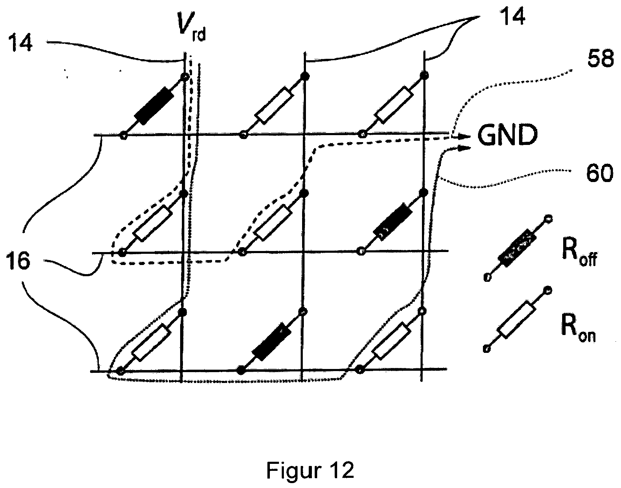

Figur 12 verdeutlicht die Problematik parasitärer Ströme in einer passiven Speichermatrix, die den Anlass zu der vorliegenden Erfindung gegeben hat. Jede Wordline 14 ist mit jeder Bitline 16 unmittelbar nur über ein einziges resistives Speicherelement 22 verbunden. Innerhalb der Speichermatrix sind diese Wordline und diese Bitline aber durch verschiedene parasitäre Strompfade 58, 60 verbunden, die jeweils mindestens eine weitere Wordline und/oder Bitline und eine Vielzahl weiterer resistiver Speicherelemente enthalten. Mit Speicherelementen nach dem Stand der Technik sinkt der beim Anlegen der Auslesespannung V_{R} erzielbare Spannungshub zwischen den Zuständen 0 und 1 des addressierten Speicherelements mit zunehmender Größe der Speichermatrix schnell ab und ist stark abhängig vom in die Speichermatrix eingeschriebenen Bitmuster. In einem Worst-Case-Szenario beträgt der Spannungshub schon in einem Array mit nur 8x8 Speicherelementen gerade einmal 10 % der Versorgungsspannung. Niedriger Spannungshub und Bitmusterabhängigkeit erfordern große Verstärker zum Detektieren des Spannungshubs, begrenzen den Anwendungsbereich der Speichermatrix auf geringe Anzahlen von Speicherelementen und begrenzen ebenfalls die Zugriffszeit. Die statische Verlustleistung durch die parasitären Strompfade, die sowohl beim Lesen als auch beim Schreiben auftritt, ist ein zusätzliches Problem.

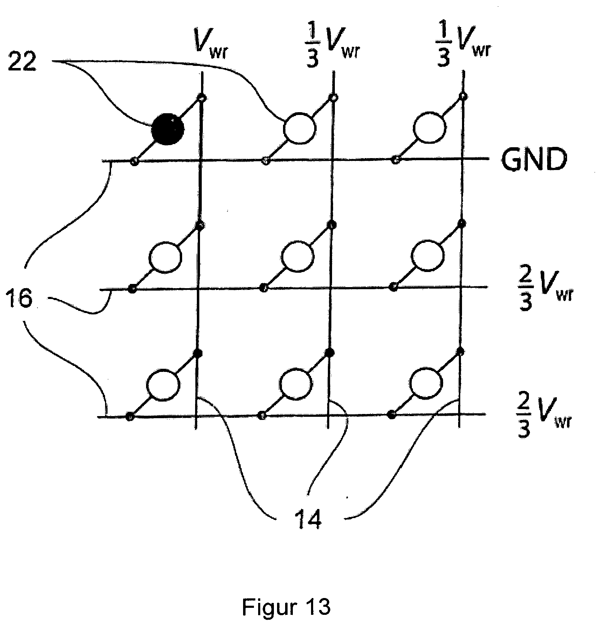

Figur 13 zeigt ein Ausführungsbeispiel des 2/3-Spannungsschemas, das beim Schreiben von Information in ein Speicherelement 22 einer Speichermatrix die Beeinflussung nicht adressierter Speicherelemente verhindert. Nur über dem adressierten Speicherelement fällt die volle Schreibspannung V_{wr} ab. Der Spannungsabfall über allen anderen Speicherelementen ist auf 1/3 V_{wr} begrenzt.

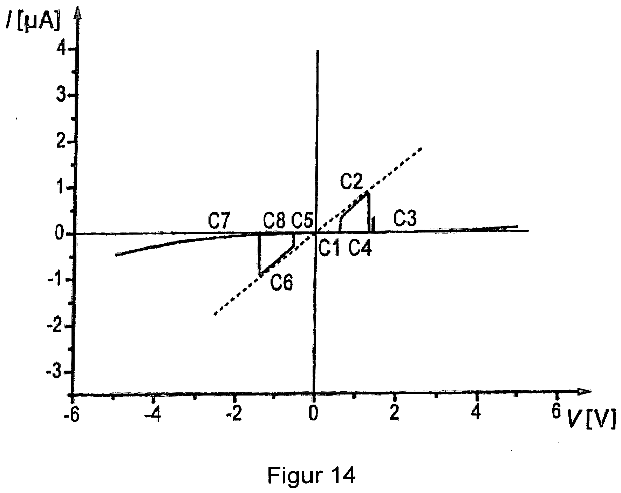

Figur 14 zeigt die I-V-Kennlinie eines erfindungsgemäßen Speicherelements. Sie ist vergleichbar mit der Kennlinie in Figur 1 c. Im Gegensatz zu Figur 1c ist es jedoch nicht die berechnete Kennlinie eines idealen Speicherelements, sondern die gemessene Kennlinie eines tatsächlich realisierten Speicherelements aus Germaniumselenid.

Zu Beginn der Messung (Bereich C1) ist Speicherzelle A des Speicherelements im Zustand A0, und Speicherzelle B ist im Zustand B1. Wegen der Reihenschaltung ist der Gesamtwiderstand hoch. Fast die gesamte Spannung fällt über Speicherzelle A ab, bis die erste positive Schaltschwelle V_{th,1} erreicht wird und die Speicherzelle A in den Zustand A1 mit geringem Widerstand umschaltet. Da die Speicherzelle B im Zustand B1 bleibt und somit ebenfalls geringen Widerstand hat, ist im Bereich C2 der Gesamtwiderstand des Speicherelements gering. Erreicht die Spannung die zweite positive Schaltschwelle V_{th,2}, schaltet die Speicherzelle B in den Zustand B0 mit hohem Widerstand um. Daher ist im Bereich C3 der Gesamtwiderstand des Speicherelements wieder hoch. Wird die Spannung nun wieder in Richtung Null verringert, bleibt die Speicherzelle A im Zustand A1 und die Speicherzelle B im Zustand B0 (Bereich C4). Daran ändert sich zunächst auch dann nichts, wenn die Spannung negativ wird (Bereich C5). Erst wenn die erste negative Schaltschwelle -V_{th,1} erreicht wird, schaltet die Speicherzelle B, über die fast die gesamte Spannung abfällt, in den Zustand B1. Da die Speicherzelle A im Zustand A1 bleibt, wird der Gesamtwiderstand des Speicherelements gering (Bereich C6). Wenn die Spannung weiter negativ wird und die zweite negative Schaltschwelle -V_{th,2} erreicht, wird die Speicherzelle A in den Zustand A0 umgeschaltet, und der Gesamtwiderstand des Speicherelements ist wieder hoch (Bereiche C7 und C8).

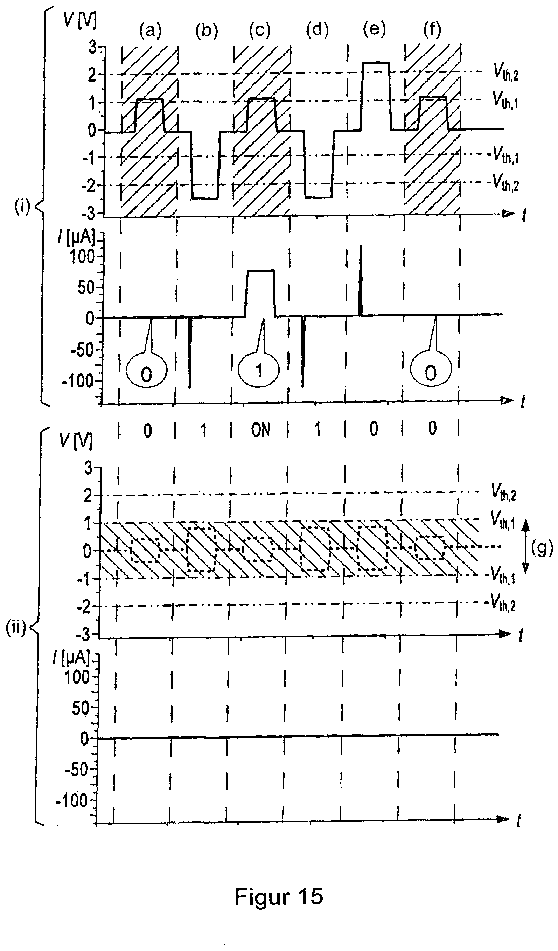

Figur 15 zeigt eine beispielhafte Abfolge von Spannungspulsen, mit der ein erfindungsgemäßes Speicherelement in einer erfindungsgemäßen Speichermatrix beaufschlagt werden kann, sowie die von diesen Spannungspulsen durch das Speicherelement getriebenen Ströme (i). Dargestellt sind auch diejenigen parasitären Spannungen, die durch die Spannungspulse an einem nicht adressierten Speicherelement der Speichermatrix bewirkt werden, sowie die parasitären Ströme, die durch diese parasitären Spannungen durch das nicht adressierte Speicherelement getrieben werden (ii). In Figur 14 ist V_{th,1} jeweils der Betrag der Spannung, die mindestens benötigt wird, um die erste Speicherzelle A des Speicherelements umzuschalten. V_{th,1} ist somit das Minimum für die Auslesespannung V_{R}. V_{th,2} ist der Betrag der Spannung, die benötigt wird, um auch die zweite Speicherzelle B des Speicherelements umzuschalten. Um zwischen den Zuständen 0 und 1 des Speicherelements insgesamt zu wechseln, müssen jeweils beide Speicherzellen A und B umgeschaltet werden. In Figur 14 ist zum Umschalten in den Zustand 0 eine Schreibspannung V₀ ≥ V_{th,2} erforderlich, und zum Umschalten in den Zustand 1 ist eine Schreibspannung V₁ ≤ -V_{th,2} erforderlich.

Ausgehend vom Zustand 0 des adressierten Speicherelements wird das Speicherelement ausgelesen (a), in den Zustand 1 versetzt (b), ausgelesen (c), es wird die 1 wieder eingeschrieben (d), das Speicherelement wird in den Zustand 0 versetzt (e), und es wird schließlich ausgelesen (f). Beim Auslesen fließt jeweils nur dann ein relevanter Lesestrom, wenn das Speicherelement zuvor im Zustand 1 war. Die an den nicht adressierten Speicherelementen abfallende Spannung ist zu gering, um eine der Speicherzellen A oder B umschalten zu können. Somit bleibt der Zustand aller nicht adressierten Speicherelemente unverändert (g).

Die Erfindung bezieht sich auch auf ein Verfahren zum Schreiben von Information in eine Mehrzahl der vorgenannten bipolaren passiv schaltenden resistiven Speicherelemente. Bei diesem Verfahren werden die folgenden Schritte durchgeführt:
- Die Zellen werden mit einem Schreibspannungspuls einer ersten Polarität beaufschlagt, um sie in einen ersten Zustand umzuschalten, und
- anschließend werden die Zellen mit einem Schreibspannungspuls der gleichen oder aber der entgegengesetzten Polarität beaufschlagt.

Dabei liegt die Spannung jedes der Schreibpulse betragsmäßig über dem Schwellwert V_{th,2}, der erforderlich ist, um beide Speicherzellen A und B des Speicherelements umzuschalten.

Die Erfindung bezieht sich auch auf ein Verfahren zum Auslesen von Information, die in einer Mehrzahl bipolar resistiv schaltender Speicherelemente, insbesondere erfindungsgemäßer bipolar resistiv schaltender Speicherelemente, gespeichert ist. Bei diesem Verfahren werden die folgenden Schritte durchgeführt:
- die Speicherelemente werden mit einem Schreibpuls einer ersten Polarität beaufschlagt, der die Speicherelemente in einen ersten Zustand schaltet, und
- anschließend wird eines der Speicherelemente mit einer Auslesespannung beaufschlagt, und der dadurch bewirkte Lesestrom wird gemessen.

Dabei liegt die Spannung des Schreibpulses betragsmäßig über dem Schwellwert V_{th,2}, der zum Umschalten beider Speicherzellen A und B des Speicherelements erforderlich ist. Die Auslesespannung ist geringer als V_{th,2}. Sie ist vorteilhaft größer als Vt_{h,1}.

## Patentansprüche

1. Speicherelement mit mindestens einem ersten stabilen Zustand 0 und einem zweiten stabilen Zustand 1,welches durch Anlegen einer ersten Schreibspannung V₀ in den Zustand 0 und durch Anlegen einer zweiten Schreibspannung V₁ in den Zustand 1 überführbar ist, wobei die beiden Zustände 0 und 1 sich bei Anlegen einer Auslesespannung V_{R}, welche betragsmäßig kleiner ist als die Schreibspannungen V₀ und V₁, in unterschiedlichen elektrischen Widerstandswerten des Speicherelements manifestieren, **dadurch gekennzeichnet, dass** das Speicherelement eine Serienschaltung von mindestens zwei Speicherzellen A und B aufweist, welche jeweils einen stabilen Zustand A0 bzw. B0 mit höherem elektrischem Widerstand und einen stabilen Zustand A1 bzw. B1 mit geringerem elektrischem Widerstand aufweisen.

2. Speicherelement nach vorhergehendem Anspruch, **dadurch gekennzeichnet, dass** die Speicherzellen A und B derart verschaltet sind, dass der Zustand 0 des Speicherelements in der Kombination der Zustände A1 und B0 kodiert ist und dass der Zustand 1 des Speicherelements in der Kombination der Zustände A0 und B1 kodiert ist.

3. Speicherelement nach vorhergehendem Anspruch, **gekennzeichnet durch** eine derartige Dimensionierung der Speicherzellen A und B sowie der Auslesespannung V_{R}, dass die Auslesespannung V_{R} den Zustand A1 einstellt und den Zustand der Speicherzelle B unverändert lässt.

4. Speicherelement nach einem der vorhergehenden Ansprüche, **dadurch gekennzeichnet, dass** die Schreibspannungen V₀ und V₁ unterschiedliche Vorzeichen aufweisen.

5. Speicherelement nach einem der vorhergehenden Ansprüche, **dadurch gekennzeichnet, dass** es als bipolar schaltendes Speicherelement ausgebildet ist.

6. Speicherelement nach einem der vorhergehenden Ansprüche, **dadurch gekennzeichnet, dass** die Speicherzellen A und B jeweils aus einem linear bipolar resistiv schaltenden Material gebildet sind.

7. Speicherelement nach einem der vorhergehenden Ansprüche, **dadurch gekennzeichnet, dass** mindestens eine der Speicherzellen A und B Siliziumdioxid, Methylsilsesquioxan, methyliertes-hydrogeniertes Silsesquioxan, Wolframoxid, Germaniumselenid, Titandioxid und/oder Strontiumtitanat als aktives Material mit veränderlichem elektrischem Widerstand enthält.

8. Speicherelement nach einem der vorhergehenden Ansprüche, **dadurch gekennzeichnet, dass** die Speicherzellen A und B antiseriell verschaltet sind.

9. Speicherelement nach vorhergehendem Anspruch, **dadurch gekennzeichnet, dass** die Speicherzellen A und B in den Zuständen A0 und B0 bzw. A1 und B1 jeweils nominell gleiche Widerstandswerte aufweisen.

10. Speicherelement nach einem der vorhergehenden Ansprüche, **gekennzeichnet durch** eine derartige Dimensionierung der Speicherzellen A und B, dass sich der elektrische Widerstand mindestens einer der Speicherzellen A und B beim Übergang vom Zustand A0 in den Zustand A1 bzw. vom Zustand B0 in den Zustand B1 um einen Faktor zwischen 10 und 10⁸, bevorzugt zwischen 10² und 10⁶, ändert.

11. Speicherelement nach vorhergehendem Anspruch, **dadurch gekennzeichnet, dass** sich der elektrische Widerstand mindestens einer der Speicherzellen A und B beim Übergang vom Zustand A0 in den Zustand A1 bzw. vom Zustand B0 in den Zustand B1 um einen Faktor zwischen 10³ und 10⁵ ändert.

12. Speicherelement nach einem der vorhergehenden Ansprüche, **dadurch gekennzeichnet, dass** es als Stapelung aus einer ersten metallischen, halbleitenden oder leitfähigen oxidischen Elektrode, einer ersten Schicht aktiven Materials mit veränderlichem elektrischem Widerstand, einer zweiten metallischen, halbleitenden oder leitfähigen oxidischen Elektrode, einer weiteren Schicht aktiven Materials mit veränderlichem elektrischem Widerstand und einer dritten metallischen, halbleitenden oder leitfähigen oxidischen Elektrode ausgebildet ist.

13. Speicherelement nach vorhergehendem Anspruch, **dadurch gekennzeichnet, dass** sich wenigstens das Metall der zweiten Elektrode vom Material der ersten und/oder der dritten Elektrode unterscheidet.

14. Speicherelement nach vorhergehendem Anspruch, **dadurch gekennzeichnet, dass** mindestens das Metall der zweiten Elektrode edler oder unedler ist als die Metalle der ersten und der dritten Elektrode.

15. Speicherelement nach einem der vorhergehenden 3 Ansprüche, **dadurch gekennzeichnet, dass** mindestens eine der Elektroden ein Material aus der Gruppe Au, Cu, Ag, Pt, W, Ti, Al, Ni, TiN, Pd, Ir, Os, IrO₂, RuO_{2,} SrRuO₃, polykristallines Silizium enthält.

16. Speicherelement nach einem der vorhergehenden Ansprüche, **dadurch gekennzeichnet, dass** mindestens eine der Speicherzellen A oder B aus zwei
Elektroden besteht, an deren gemeinsamer Grenzfläche sich eine Zone mit geänderter Ladungsträgerkonzentration als aktives Material bildet.

17. Speicherelement nach vorherigem Anspruch, **dadurch gekennzeichnet, dass** das Material der einen Elektrode ein dotiertes ternäres Metalloxid und das Material der anderen Elektrode ein Metall ist.

18. Speicherelement nach einem der vorhergehenden Ansprüche, **dadurch gekennzeichnet, dass** ein weiterer Widerstand R mit den Speicherzellen A und B in Serie geschaltet oder in mindestens eine der Speicherzellen A und/oder B eingebracht ist.

19. Speicherelement nach vorhergehendem Anspruch, **gekennzeichnet durch** eine derartige Dimensionierung des Widerstands R, dass die positiven und negativen Schaltschwellen mindestens einer der Speicherzellen A und/oder B betragsmäßig aneinander angeglichen werden.

20. Speicherelement nach einem der vorhergehenden Ansprüche, **dadurch gekennzeichnet, dass** mindestens eine der Speicherzellen ein ionenleitendes Material als aktives Material enthält.

21. Speicherelement nach einem der vorhergehenden Ansprüche, **dadurch gekennzeichnet, dass** mindestens eine der Speicherzellen GeSe oder MSQ als aktives Material enthält.

22. Stapelung aus mindestens zwei Speicherelementen P und Q nach einem der vorhergehenden Ansprüche, **dadurch gekennzeichnet, dass** ein Pol des Speicherelements P über einen für eine externe Beschaltung zugänglichen elektrischen Kontakt O mit einem Pol des Speicherelements Q verbunden ist.

23. Speichermatrix mit einer Vielzahl von als Leiterbahnen ausgebildeten Wordlines und diese kreuzenden Bitlines, **dadurch gekennzeichnet, dass** an Kreuzungsorten von Wordlines und Bitlines Speicherelemente oder Stapelungen nach einem der vorhergehenden Ansprüche angeordnet sind.

24. Speichermatrix nach vorhergehendem Anspruch, **dadurch gekennzeichnet, dass** die Wordlines und/oder die Bitlines parallel zueinander verlaufen.

25. Speichermatrix nach einem der vorhergehenden 2 Ansprüche, **dadurch gekennzeichnet, dass** jede Wordline und jede Bitline einander an höchstens einem Ort kreuzen.

26. Speichermatrix nach einem der vorhergehenden 3 Ansprüche, **dadurch gekennzeichnet, dass** die Wordline und die Bitline an jedem Kreuzungsort jeweils mit höchstens einem Speicherelement oder einer Stapelung leitend verbunden sind.

27. Speichermatrix nach einem der vorhergehenden 4 Ansprüche, **dadurch gekennzeichnet, dass** an jedem Kreuzungsort höchstens ein Speicherelement oder eine Stapelung zwischen die Wordline und die Bitline geschaltet ist.

28. Speichermatrix nach einem der vorhergehenden 5 Ansprüche, **dadurch gekennzeichnet, dass** sie als dreidimensionale Speichermatrix ausgebildet ist.
